(19) Europäisches Patentamt
European Patent Office
Office européen des brevets

(11) **EP 1 905 157 B1**

(12) **FASCICULE DE BREVET EUROPEEN**

(45) Date de publication et mention
de la délivrance du brevet:
**02.11.2016 Bulletin 2016/44**

(51) Int Cl.:
***H03M 13/11*** *(2006.01)*

(21) Numéro de dépôt: **06778997.4**

(22) Date de dépôt: **30.06.2006**

(86) Numéro de dépôt international:
**PCT/FR2006/050653**

(87) Numéro de publication internationale:
**WO 2007/003855 (11.01.2007 Gazette 2007/02)**

(54) **PROCEDE ET SYSTEME D'ENCODAGE D'UNE SEQUENCE DE DONNEES**

VERFAHREN UND VORRICHTUNG ZUR KODIERUNG EINER DATENFOLGE

METHOD AND SYSTEM FOR ENCODING A DATA SEQUENCE

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **01.07.2005 FR 0507007**

(43) Date de publication de la demande:
**02.04.2008 Bulletin 2008/14**

(73) Titulaire: **Orange**
**75015 Paris (FR)**

(72) Inventeurs:
• **DORE, Jean-Baptiste**
**F-35510 Cesson Sevigne (FR)**
• **HAMON, Marie-Hélène**
**F-35530 Noyal Sur Vilaine (FR)**
• **PENARD, Pierre**
**F-35000 Rennes (FR)**

(74) Mandataire: **Fontenelle, Sandrine et al**
**Cabinet Beau de Loménie**
**158, rue de l'Université**
**75340 Paris Cedex 07 (FR)**

(56) Documents cités:
**EP-A- 1 531 552**

• **ECHARD R ET AL: "THE PI-ROTATION LOW-DENSITY PARITY CHECK CODES" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY : IEEE, US, vol. VOL. 2 OF 6, 25 novembre 2001 (2001-11-25), pages 980-984, XP001099251 ISBN: 0-7803-7206-9 cité dans la demande**
• **YU YI ET AL: "The semi-algebra low-density parity-check codes" COMMUNICATIONS, 2004 IEEE INTERNATIONAL CONFERENCE ON PARIS, FRANCE 20-24 JUNE 2004, PISCATAWAY, NJ, USA,IEEE, 20 juin 2004 (2004-06-20), pages 440-443, XP010710384 ISBN: 0-7803-8533-0**
• **ECHARD R ET AL: 'Deterministic and b pi;-rotation low-density parity check codes' ELECTRONICS LETTERS, IEE STEVENAGE, GB vol. 38, no. 10, 09 Mai 2002, pages 464 - 465, XP006018212 ISSN: 0013-5194**
• **ECHARD R ET AL: "Irregular /spl pi/-rotation LDPC codes" GLOBECOM'02. 2002 - IEEE GLOBAL TELECOMMUNICATIONS CONFERENCE. CONFERENCE PROCEEDINGS. TAIPEI, TAIWAN, NOV. 17 - 21, 2002, IEEE GLOBAL TELECOMMUNICATIONS CONFERENCE, NEW YORK, NY : IEEE, US, vol. VOL. 1 OF 3, 17 novembre 2002 (2002-11-17), pages 1274-1278, XP010636350 ISBN: 0-7803-7632-3**

- YANG M ET AL: "Design of efficiently encodable moderate-length high-rate irregular LDPC codes" IEEE TRANSACTIONS ON COMMUNICATIONS, IEEE SERVICE CENTER, PISCATAWAY, NJ, US, vol. 52, no. 4, avril 2004 (2004-04), pages 564-571, XP002312175 ISSN: 0090-6778 cité dans la demande
- XIAO-YU HU ET AL: "On the computation of the minimum distance of low-density parity-check codes" COMMUNICATIONS, 2004 IEEE INTERNATIONAL CONFERENCE ON PARIS, FRANCE 20-24 JUNE 2004, PISCATAWAY, NJ, USA,IEEE, 20 juin 2004 (2004-06-20), pages 767-771, XP010710425 ISBN: 0-7803-8533-0 cité dans la demande
- YIFEI ZHANG ET AL: "Structured eIRA Codes" SIGNALS, SYSTEMS AND COMPUTERS, 2004. CONFERENCE RECORD OF THE THIRTY-EIGHTH ASILOMAR CONFERENCE ON PACIFIC GROVE, CA, USA NOV. 7-10, 2004, PISCATAWAY, NJ, USA,IEEE, 7 novembre 2004 (2004-11-07), pages 2005-2009, XP010781401 ISBN: 0-7803-8622-1
- PNG K-B ET AL: "Performance studies of a multi-band OFDM system using a simplified LDPC code" ULTRA WIDEBAND SYSTEMS, 2004. JOINT WITH CONFERENCE ON ULTRAWIDEBAND SYSTEMS AND TECHNOLOGIES. JOINT UWBST & IWUWBS. 2004 INTERNATIONAL WORKSHOP ON KYOTO, JAPAN MAY 18-21, 2004, PISCATAWAY, NJ, USA,IEEE, 18 mai 2004 (2004-05-18), pages 376-380, XP010715179 ISBN: 0-7803-8373-7

## Description

### Domaine technique de l'invention

L'invention se rapporte au domaine des communications numériques et concerne un procédé de construction d'un code LDPC pour l'encodage et le décodage d'une séquence de données ainsi que des dispositifs d'encodage et de décodage.

### Arrière-plan de l'invention

Actuellement, les systèmes de communication numérique les plus performants s'appuient sur des systèmes où les donnés sont protégées par un codage de canal très performant et décodées itérativement par un décodeur à sortie pondérée.

Dans le domaine des transmissions numériques, et plus particulièrement lorsque le canal est de type hertzien, la fonction principale de ces codes correcteurs est de permettre la levée des ambiguités apportées par le canal sur le message transmis. Le gain en performance apporté par ces codes peut être affecté à la réduction de consommation des terminaux ou à l'augmentation du volume d'informations transmis.

Récemment, de nombreux travaux ont été réalisés dans le domaine d'encodage et de décodage en utilisant des codes correcteurs dit codes LDPC (*Low Density Parity Check*). Des codes LDPC sont proposés par exemple dans le cadre de la normalisation du IEEE 802.11n WLAN haut débit et ont été adoptés dans la norme IEEE 802.16.e (Wimax mobile).

Les techniques de codage de canal mettant en oeuvre des codes LDPC sont nombreuses. Cependant un inconvénient majeur des codes LDPC est leur complexité d'encodage. Toutefois, plusieurs familles de codes LDPC permettent une simplification du processus d'encodage. Tous ces codes ont en commun une matrice de contrôle de parité notée H de forme triangulaire. De plus il a été montré que pour des tailles de blocs de l'ordre de quelques Kilo bits, les constructions déterministes ou pseudo déterministes des matrices de contrôle de parités définissant un code LDPC donnent de meilleures performances que les constructions aléatoires.

Dans la suite, on notera $N$ la taille d'un mot de code x composé de $M$ bits de parité formant le vecteur de parité P et de $K$ bits d'informations ou de données formant le vecteur de données $C$. Le rendement $R$ du code est donné par la formule suivante:

$$R = \frac{K}{N}$$

La matrice $H$ de contrôle de parité du code est de taille $M \times N$ et chaque équation de parité est composée de $d_c$ variables, et chaque variable est connectée à $d_v$ équations. Par ailleurs, un code est dit régulier si chaque variable est connecté au même nombre d'équation et si chaque équation a le même nombre de variable, ce qui correspond à une matrice de contrôle de parité comportant le même nombre de "1" par ligne et le même nombre de "1" par colonne.

En outre, cette matrice de contrôle de parité $H$ peut être définie par deux sous matrices telles que:

$$H = \begin{bmatrix} H_1 & H_p \end{bmatrix}$$

$H_p$ est une matrice carrée de taille $M \times M$ associée aux bits de parité du vecteur de parité $P$, et $H_1$ est une matrice de taille $M \times K$ associée aux bits d'informations du vecteur de données $C$. Ainsi, un mot x décomposé en bits d'informations et bits de parité de la façon suivante $x=[C\ P]$ est un mot de code si et seulement si:

$$Hx^T = \begin{bmatrix} H_1 & H_p \end{bmatrix}\begin{bmatrix} C^T \\ P^T \end{bmatrix} = 0^T$$

$x^T$, $C^T$, et $P^T$ étant les transposées des vecteurs x, C, et P. Par ailleurs, on appelle vecteur de projection $V$, le vecteur définit par la relation suivante :

$$V^T = H_1 C^T$$

Le document de Michael Yang, W.E. Ryan, and Yan Li, intitulé "Design of efficiently encodable moderate-length high-rate irregular LDPC codes" (IEEE Transactions on Communications, avril 2004) décrit la construction d'un code LDPC par une matrice de contrôle de parité de la forme $H=\lfloor H_1\ H_p \rfloor$. Cette matrice $H$ est pseudo déterministe et permet un calcul rapide des bits de redondance. La matrice $H_1$ est une matrice générée aléatoirement et la matrice $H_p$ est une matrice de forme diagonale. Les bits de parité du vecteur de parité $P$ sont calculés à partir des bits d'informations du vecteur de données C suivant la relation suivante:

$$P = H_p^{-1} H_1 C$$

Du fait de la forme triangulaire de la matrice $H_p$, son inverse $H_p^{-1}$ a une forme particulièrement intéressante qui permet un calcul simple des bits de parités à partir du produit $H_1 C$.

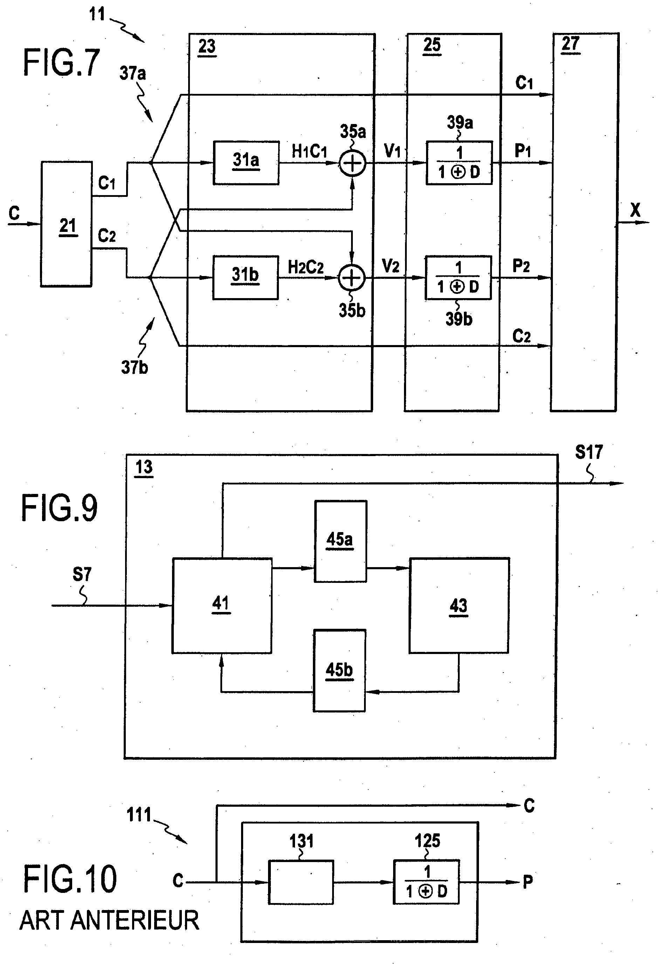

En effet, la figure 10 illustre schématiquement un dispositif d'encodage comportant un moyen de contrôle 131 et un moyen de codage 125 traduisant le calcul des bits de parités suivant la relation $P = H_p^{-1} H_1 C$.

Cependant, en dépit du caractère pseudo déterministe du code construit à partir des matrices de ce type, la matrice de contrôle de parité $H$ est très peu structurée. Le manque de structure de la matrice $H_1$ générée aléatoirement rend le calcul du produit $H_1C$ très complexe. De plus, dans cette configuration il est nécessaire de stocker à l'émission, la matrice $H_1$ ce qui est très coûteux d'un point de vue de réalisation pratique.

Afin de simplifier le calcul, S.J. Johnson et S.R. Weller proposent dans leur publication "Quasi-cyclic LDPC codes from differences families" (3rd Australian Communications Theory Worshop, Canberra, Australia, février 2002), un code construit à partir d'une matrice de contrôle de parité déterministe et quasi cyclique.

Cette matrice H est décomposée en plusieurs sous matrices. Chaque sous matrice est une matrice identité dont les colonnes sont permutées circulairement $k$ fois vers la gauche ou vers la droite. Cette forme de matrice permet une paramétrisation simple d'un code LDPC. Cette structure permet également une réduction de la complexité d'encodage.

De même, R.Echard et S-C Chang proposent dans leur publication "The pi rotation Low Density Parity Check Codes", (GLOBECOM 2001, novembre 2001, pp. 980-984), un code construit à partir d'une matrice de contrôle de parité déterministe suivant une technique des matrices Pi-rotation. Cette matrice de contrôle de parité $H$ est divisée en deux sous matrices, $H_\pi$ et $H_p$ telles que $H = \llcorner H_\pi H_p \lrcorner$ où $H_p$ est une matrice de forme bi diagonale. L'originalité de cette construction provient de la forme de la matrice $H_\pi$ qui permet un calcul rapide et peu coûteux d'un point de vue implémentation du produit $H_\pi C$.

Les codes générés à partir des matrices déterministes du type quasi cyclique ou Pi-rotation sont structurés ce qui permet une réduction de la complexité d'encodage. Cependant, ce genre de matrices génère des codes ayant une distance minimale faible. Notamment pour un nombre donné de "1" par colonne la distance minimale n'augmente pas avec la taille des blocs. Ainsi, ces codes peuvent présenter des dégradations de performance pour des taux d'erreurs faibles sachant que la distance minimale est directement reliée à la performance d'un code.

Objet et résumé de l'invention

L'invention a pour but de remédier à ces inconvénients, et de simplifier le processus d'encodage.

Ces buts sont atteints grâce à un procédé de construction d'un code LDPC par une matrice de contrôle de parité, chaque colonne de ladite matrice de contrôle de parité définissant un nombre déterminé de bits codés et chaque ligne définissant une équation de parité, caractérisé en ce que ladite matrice de contrôle de parité comporte deux zones matricielles, chaque zone matricielle comprenant au moins une matrice de traitement, une matrice de liaison comportant un unique « 1 » par colonne et un unique « 1 » par ligne, et une matrice triangulaire.

Ainsi, la matrice de contrôle de parité est une matrice structurée qui simplifie le processus d'encodage tout en générant des codes ayant une distance minimale suffisamment grande pour permettre de bonnes performances pour ces codes.

L'invention vise aussi un procédé d'encodage d'une séquence de données suivant un code LDPC défini par la matrice de contrôle de parité, comportant les étapes suivantes :

- décomposer la séquence de données en un ensemble de vecteurs de données comportant un nombre déterminé de vecteurs de données;
- détermination de vecteurs de parité correspondant aux vecteurs de données respectant l'ensemble des équations de parité définis par ladite matrice de contrôle de parité, et
- associer l'ensemble de vecteurs de données avec les vecteurs de parité pour former un mot de code comportant une pluralité de bits de données et une pluralité de bits de parité.

Ainsi, l'encodage d'une séquence de données est réalisé avec une complexité réduite à partir de la matrice de contrôle de parité.

La détermination desdits vecteurs de parité comporte les étapes suivantes :

- transformer par un ensemble de projections en parallèle ledit ensemble de vecteurs de données en vecteurs de projection ;
- multiplier chacun des vecteurs de projection par l'inverse d'une matrice triangulaire de ladite matrice de contrôle de parité pour former lesdits vecteurs de parité.

Ainsi, le traitement en parallèle des vecteurs de données permet d'augmenter la rapidité de l'encodage et par conséquent d'augmenter le débit des mots codés.

Dans le cas où le nombre déterminé de vecteurs de données est égal à deux, ladite étape de transformation par projections en parallèle comporte les étapes suivantes :

- réaliser des opérations en parallèle comportant des opérations de contrôle et de permutation sur lesdits deux vecteurs de données pour former deux vecteurs de contrôle et deux vecteurs de permutation,
- additionner lesdits deux vecteurs de contrôle auxdits deux vecteurs de permutation pour former un ensemble de vecteurs de projection constitué desdits deux vecteurs de projection de telle sorte qu'un vecteur de contrôle en sortie d'une opération de contrôle d'un vecteur de données est additionné à un vecteur de permutation en sortie d'une opération de permutation de l'autre vecteur de données.

Ceci permet un brassage de différents codes encodés en parallèle de façon à obtenir un bon niveau de performance sans trop augmenter la complexité du processus d'encodage.

Par ailleurs, dans le cas où le nombre déterminé de vecteurs de données est supérieur à deux, ladite étape de transformation par projections en parallèle comporte les étapes suivantes :

- réaliser des opérations en parallèle comportant des opérations de contrôle et de permutation sur ledit ensemble de vecteurs de données pour former un ensemble de vecteurs de contrôle et un ensemble de vecteurs de permutation,
- additionner ledit ensemble de vecteurs de contrôle audit ensemble de vecteurs de permutation pour former un ensemble de vecteurs de projection de telle sorte qu'un vecteur de contrôle en sortie d'une opération de contrôle d'un vecteur de données quelconque est additionné à un vecteur de permutation en sortie d'une opération de permutation d'un autre vecteur de données, et
- additionner deux-à-deux les vecteurs de projection dudit ensemble de vecteurs de projection pour former un autre ensemble de vecteurs de projections, l'addition étant réalisée entre deux vecteurs de projection ne dépendant pas des mêmes vecteurs de données, et
- si l'autre ensemble de vecteurs de projection comporte plus que deux vecteurs de projection, alors recommencer l'étape précédente jusqu'à l'obtention de deux vecteurs de projection.

Ceci permet un brassage entre les différents codes encodés en parallèle de façon à améliorer le niveau de performance.

Lors de la formation dudit ensemble de vecteurs de projection, chaque vecteur de permutation dudit ensemble de vecteurs de permutation est utilisé de manière unique.

Ceci permet d'optimiser le traitement parallèle et d'augmenter le brassage améliorant la performance du codage.

Avantageusement, ladite opération de contrôle comporte la multiplication de chaque vecteur de données par une matrice de traitement de ladite matrice de contrôle de parité et en ce que ladite opération de permutation comporte la multiplication de chaque vecteur de données par une matrice de liaison de ladite matrice de contrôle de parité.

Ainsi, les structures des matrices de liaison et de traitement diminuent la complexité tout en permettant un encodage simple à réaliser.

Les matrices de liaison de ladite matrice de contrôle de parité peuvent être identiques. Ceci permet le stockage d'un nombre réduit de données facilitant ainsi le procédé d'encodage.

Avantageusement, lesdites matrices de liaison peuvent être des matrices identité permettant ainsi de réduire encore davantage le nombre de données à stocker.

Selon un mode de réalisation de la présente invention, la matrice triangulaire est une matrice bi-diagonale comportant deux diagonales de « 1 » espacées par un nombre donné n de diagonales de « 0 ».

Ainsi, ce type de matrice de parité est inversible et permet de produire des bits de parité de manière simple et rapide.

Avantageusement, le procédé d'encodage peut comporter en outre une étape de poinçonnage des bits de parités dudit mot de code. Le poinçonnage permet d'élargir la gamme de rendements du code.

L'invention vise aussi un procédé de décodage d'un signal de réception comportant des bits codés, ledit signal de réception étant issu d'un ensemble de mots de code codés suivant le code LDPC construit selon la matrice de contrôle de parité et comportant les étapes suivantes :

- résolution de chacune desdites équations de parité associées à ladite matrice de contrôle de parité pour calculer des estimations probabilistes sur les valeurs des bits codés participant à chacune desdites équations de parité,
- envoi desdites estimations probabilistes à l'ensemble des bits codés participant à chacune desdites équations de parité,
- calcul pour chaque bit codé d'une nouvelle estimation probabiliste à partir des estimations probabilistes provenant des équations de parité associées à chaque bit codé,
- mises à jour des estimations probabilistes au niveau des équations de parité, et
- réitération des étapes précédentes jusqu'à ce qu'une condition d'arrêt prédéterminée soit respectée.

Ainsi, le décodage est réalisé de manière itérative à partir de la matrice de contrôle de parité.

La condition d'arrêt prédéterminée peut être définie par un nombre déterminé d'itérations, et/ou par une convergence du décodage vers un mot de code.

Ainsi, selon la condition d'arrêt choisi, on peut augmenter la rapidité ou la performance du décodage.

L'invention vise aussi un système de communication comportant une première entité comprenant une source d'information et un dispositif encodeur, connectée via un canal de transmission de données à une seconde entité comportant un dispositif décodeur, le dispositif encodeur étant destiné à encoder une séquence de données émise par la source d'information pour former un ensemble de mots de code à partir d'une matrice de contrôle de parité comportant au-moins deux zones matricielles, chaque zone matricielle comprenant au moins une matrice de traitement, une matrice de liaison comportant un unique « 1 » par colonne et un unique « 1 » par ligne, et une matrice triangulaire ; et le dispositif décodeur étant destiné à décoder un signal codé de réception reçu par la seconde entité, ledit signal codé de réception étant issu de l'ensemble de mots de code construit selon ladite matrice de contrôle de parité.

L'invention vise également un dispositif d'encodage d'une séquence de données, comportant:

- un moyen de décomposition de la séquence de données en un ensemble de vecteurs de données comportant un nombre déterminé de vecteurs de données;
- un moyen de transformation transformant par un ensemble de projections en parallèle ledit ensemble de vecteurs de données en vecteurs de projection ;
- un moyen de codage multipliant chacun des vecteurs de projection par l'inverse d'une matrice triangulaire de ladite matrice de contrôle de parité pour former des vecteurs de parité ; et
- un moyen d'association associant l'ensemble de vecteurs de données avec lesdits vecteurs de parité pour former un mot de code comportant une pluralité de bits de données et une pluralité de bits de parité.

Ainsi, le dispositif d'encodage présente une réalisation simple de génération de mots de code.

Dans le cas où le nombre déterminé de vecteurs de données est égal à deux, le moyen de transformation du dispositif d'encodage comporte :

- des moyens de contrôle multipliant en parallèle chacun des deux vecteurs de données par une matrice de traitement de ladite matrice de contrôle de parité formant deux vecteurs de contrôle ;
- des moyens de permutation multipliant en parallèle chacun des deux vecteurs de données par une matrice de liaison de ladite matrice de contrôle de parité formant deux vecteurs de permutation ; et
- des moyens d'addition additionnant lesdits deux vecteurs de contrôle auxdits deux vecteurs de permutation pour former lesdits deux vecteurs de projection de telle sorte qu'un vecteur de contrôle en sortie d'un moyen de contrôle agissant sur un vecteur de données est additionné à un vecteur de permutation en sortie d'un moyen de permutation agissant sur l'autre vecteur de données.

Par ailleurs, dans le cas où le nombre déterminé de vecteurs de données est supérieur à deux, le moyen de transformation du dispositif d'encodage comporte :

- des moyens de contrôle multipliant en parallèle chaque vecteur de données par une matrice de traitement de ladite matrice de contrôle de parité formant un ensemble de vecteurs de contrôle ;
- des moyens de permutation multipliant en parallèle chaque vecteur de données par une matrice de liaison de ladite matrice de contrôle de parité formant un ensemble de vecteurs de permutation ; et

- des premiers moyens d'addition additionnant ledit ensemble de vecteurs de contrôle audit ensemble de vecteurs de permutation pour former un ensemble de vecteurs de projection de telle sorte qu'un vecteur de contrôle en sortie d'un moyen de contrôle agissant sur un vecteur de données quelconque est additionné à un vecteur de permutation en sortie d'un moyen de permutation agissant sur un autre vecteur de données, et
- des seconds moyens d'addition additionnant de manière successive deux-à-deux les vecteurs de projection de l'ensemble de vecteurs de projection jusqu'à l'obtention de deux vecteurs de projection.

Ainsi, le dispositif réalise des calculs en parallèle permettant d'augmenter le débit des mots de code.

L'invention vise aussi un dispositif de décodage d'un signal de réception comportant des bits codés, ledit signal de réception étant issu d'un ensemble de mots de code construit selon la matrice de contrôle de parité, le dispositif comportant :

- des moyens de traitement destiné à résoudre chacune desdites équations de parité associées à ladite matrice de contrôle de parité pour calculer des estimations probabilistes sur les valeurs des bits codés participant à chacune desdites équations de parité,
- des modules de contrôle de parité, chaque module traitant de manière itérative les bits codés, et communicant avec les autres modules pour échanger les estimations probabilistes permettant aux moyens de traitement de calculer à chaque itération et pour chaque bit codé une nouvelle estimation probabiliste jusqu'à ce qu'une condition d'arrêt prédéterminée soit respectée.

Ainsi, le dispositif de décodage permet de réaliser un décodage rapide et très fiable.

L'invention vise aussi un programme d'ordinateur mis en oeuvre dans un système informatique, comportant des instructions nécessaires à la réalisation du procédé d'encodage ci-dessus.

L'invention vise également un programme d'ordinateur mis en oeuvre dans un système informatique, comportant des instructions nécessaires à la réalisation du procédé de décodage ci-dessus.

Brève description des dessins

D'autres particularités et avantages de l'invention ressortiront à la lecture de la description faite, ci-après, à titre indicatif mais non limitatif, en référence aux dessins annexés, sur lesquels :

- la figure 1 illustre schématiquement un système de communication comportant aux moins deux entités connectées entre elles via un canal de transmission de données, selon l'invention ;

- la figure 2 illustre schématiquement un dispositif d'encodage utilisant une matrice de contrôle de parité, selon l'invention ;

- la figure 3 illustre schématiquement un système informatique;

- les figures 4A et 4B illustrent des exemples schématiques d'une matrice triangulaire et de son inverse associées à des bits de parité de la matrice de contrôle de parité, selon l'invention ;

- la figure 5 illustre schématiquement un dispositif d'encodage selon la figure 2 dans lequel le nombre déterminé de vecteurs de données est égal à deux ;

- la figure 6 illustre schématiquement un moyen de codage de la figure 5 ;

- la figure 7 montre une variante du dispositif d'encodage de la figure 5 ;

- la figure 8 illustre schématiquement un dispositif d'encodage selon la figure 2 dans lequel le nombre déterminé de vecteurs de données est égal à quatre ;

- la figure 9 illustre schématiquement un dispositif de décodage utilisant la matrice de contrôle de parité, selon l'invention ; et

- la figure 10 illustre schématiquement un dispositif d'encodage, selon l'art antérieur.

Description détaillée de modes de réalisation

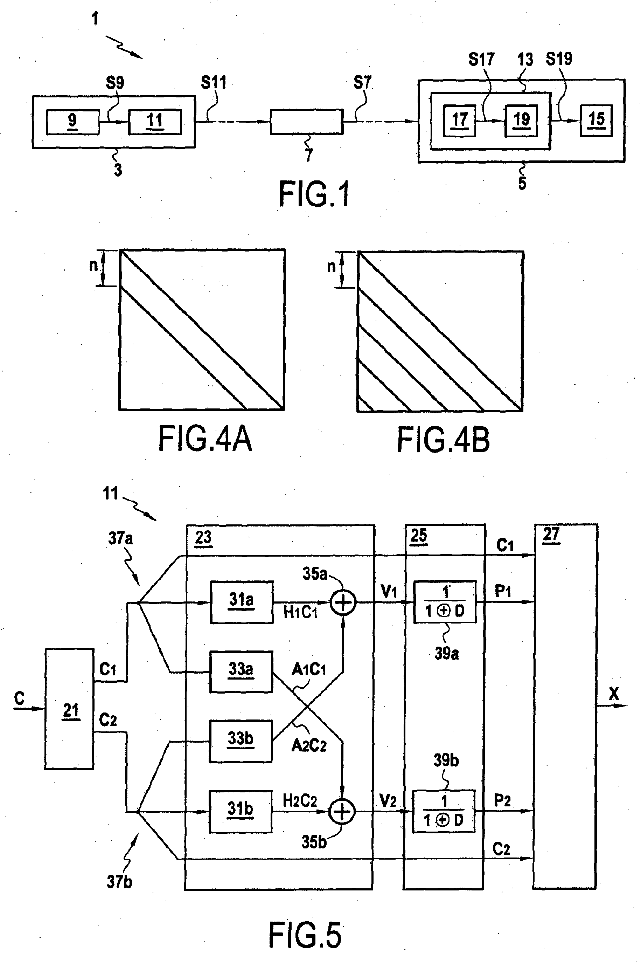

Conformément à l'invention, la figure 1 illustre un exemple schématique d'un système de communication 1 comportant aux moins deux entités 3 et 5 connectées entre elles via un canal 7 de transmission de données.

L'exemple de cette figure montre une première entité 3 comportant une source d'information 9 et un dispositif encodeur 11. La première entité 3 est connectée via le canal 7 de transmission de données à une seconde entité 5 comportant un dispositif décodeur 13 et un récepteur d'information 15.

La source d'information 9 délivre un signal d'information S9 comportant un ensemble de séquences de données C. Le dispositif encodeur 11 délivre un signal codé de transmission S11 comportant un ensemble de mots de code {x} correspondant à un codage de l'ensemble de séquences de données. Chaque mot de code x étant une association entre des vecteurs de données $C_i$ comportant des bits de données et des vecteurs de parité $P_i$ comportant des bits de parité $p_j$.

En effet, pour chaque séquence de données du signal d'information S9 émise par la source d'information 9, le dispositif encodeur 11 encode la séquence de données pour former un mot de code x suivant un code LDPC généré à partir d'une matrice de contrôle de parité H. Cette matrice de contrôle de parité $H$ comporte deux zones matricielles, chaque zone matricielle comprenant au moins une matrice de traitement $H_i$, une matrice de liaison $A_i$, et une matrice triangulaire $H_p$.

Le signal codé de transmission S11 comportant l'ensemble de mots de code est envoyé au moyen du canal 7 de transmission de données à destination de la seconde entité 5. Cette dernière reçoit alors un signal codé de réception S7 composé d'une version déformée du signal codé de transmission S11. En effet, à cause des phénomènes de propagation, les mots de code subissent d'importantes distorsions. Dans ce cas, le canal 7 de transmission de données se comporte comme une application déformante non déterministe entre le signal codé de transmission S11 à l'entrée du canal 7 et le signal codé de réception S7 à la sortie du canal 7.

Afin de compenser les effets dus à la propagation, le dispositif décodeur 13 calcul une meilleur estimation de l'ensemble de mots de code pour former un signal de code estimé S17 comportant un ensemble de mots de code estimés.

En effet, le dispositif décodeur 13 peut comporter un premier moyen de décodage 17 destiné à décoder le signal codé de réception S7 issu du signal codé de transmission S11 comportant l'ensemble de mots codés suivant le code LDPC construit selon la matrice de contrôle de parité $H$ pour former le signal de code estimé S17.

Eventuellement, le dispositif décodeur 13 comporte un second moyen de décodage 19 destiné à calculer à partir de l'ensemble de mots de code estimés une meilleure évaluation de l'ensemble de séquences de données émise par la source d'information 9 de sorte que le récepteur 15 reçoive un signal estimé d'information S19 le plus proche possible du signal d'information S9 émise par la source d'information 9.

On s'intéressera plus particulièrement, dans la description qui va suivre à la construction de la matrice de contrôle de parité H et à l'utilisation de cette matrice dans les processus d'encodage et de décodage et de leurs mises en oeuvres.

Conformément à l'invention, la matrice de contrôle de parité H comporte deux zones matricielles qui peuvent être deux lignes matricielles. Ainsi et à titre d'exemple, la matrice de contrôle de parité H peut être divisée en deux lignes matricielles et plusieurs colonnes matricielles de sorte que chaque élément est lui même une matrice (plus précisément une sous-matrice). Dans ce cas, chaque ligne matricielle comporte au moins une matrice de traitement $H_i$, une matrice de liaison $A_i$, une matrice nulle 0 et une matrice triangulaire $H_p$.

En particulier, sur une première partie de ces deux lignes matricielles, les matrices de traitement $H_i$ et de liaison $A_i$ sont disposées d'une manière alternée formant un bloc ou une matrice de projection correspondant aux bits d'informations. Par ailleurs, sur l'autre partie de ces deux lignes matricielles, les matrice nulles 0 et triangulaires $H_p$ forment un autre bloc correspondant aux bits de parité. Ainsi, cette matrice de contrôle de parité H peut être définie de la manière suivante :

$$H = \begin{bmatrix} A_1 & \cdots & H_{i-1} & A_i & H_p & 0 \\ H_i & \cdots & A_{i-1} & H_i & 0 & H_p \end{bmatrix}$$

Cette configuration permet aux matrices de traitement $H_i$ d'encoder la séquence de données de manière le plus parallèle possible. De préférence, chaque matrice de traitement $H_i$ possède une forme structurée permettant un calcul rapide. On notera que les matrices de traitement $H_i$ peuvent être identiques.

En outre, les matrices de liaisons $A_i$ permettent de coupler les différents codes réalisés en parallèle afin de les brasser et par conséquent augmenter la performance du code. On notera que chaque matrice de liaisons $A_i$ comporte un unique « 1 » par colonne et un unique « 1 » par ligne. Par ailleurs, ces matrices de liaison $A_i$ peuvent être identiques. De plus, et afin de réduire le nombre de données de la matrice de contrôle de parité H, les matrices de liaison $A_i$ peuvent être des matrices identité.

On notera que si les matrices de liaisons $A_i$ sont des matrices nulles, on peut toujours obtenir un calcul des bits de parité de manière parallèle. Dans ce cas, le décodage du code global peut se voir comme le décodage indépendant de plusieurs sous codes de tailles inférieures. Or, plus la taille du code est importante plus les performances sont bonnes. Ainsi, le fait de rendre dépendant les différents sous codes permet d'augmenter la performance.

Finalement, les formes triangulaires des matrices $H_p$ associées aux bits de parité permettent un calcul rapide de ces bits de parité. De préférence, ces matrices triangulaires $H_p$ sont des matrices bi-diagonales.

Ainsi, en développant la matrice de contrôle de parité H, chaque colonne de cette matrice définit un nombre déterminé de bits codés et chaque ligne définit une équation de parité.

La matrice de contrôle de parité H définie ci-dessus peut être réalisée en concaténant un bloc de projection correspondant aux bits d'informations comportant à l'origine deux matrices de traitement et deux matrices de liaison permettant ainsi d'étendre la taille du bloc d'information pour un même nombre de bits de parité.

Cette structure originale permet ainsi une flexibilité au niveau des tailles de bloc concernant la longueur du code ou le niveau de rendement. Par ailleurs, on notera que pour obtenir un code plus court il suffit d'utiliser un des deux sous codes définis par des matrices $H = \lfloor H_1 \ H_p \rfloor$ ou $H = \lfloor H_2 \ H_p \rfloor$ seul.

En terme de performance, la structure de la matrice de contrôle de parité H définie ci-dessus peut dépasser les performance d'autres code LDPC de taille égale et à complexité de décodage proche. Pour arriver à de telles performances il est avantageux de bien choisir chaque matrice de traitement et de trouver une bonne fonction ou matrice de liaison. Des techniques basées sur la suppression de cycles courts dans le graphe défini par la matrice de contrôle de parité H et sur la maximisation de la distance minimale peuvent être mises en oeuvre.

De plus, on peut augmenter le rendement en utilisant un poinçonnage sur les bits de parités. On notera qu'une condition nécessaire pour ne pas avoir une perte excessive de performance est de poinçonner les bits de parité de façon à ce qu'au maximum une seule des variables d'une équation de parité soit inconnue.

En outre, on peut élargir la taille de bloc de codage ou de mot de code pour un rendement donné en utilisant une expansion de la matrice de contrôle de parité. Autrement dit, chaque "1" de la matrice de contrôle de parité est remplacé par une matrice identité permutée. On peut aussi utiliser une expansion récursive de la matrice de contrôle de parité, c'est-à-dire que chaque matrice de traitement constituante d'un bloc de projection d'ordre $m$ est remplacée par une matrice de projection d'ordre $m-1$.

Alors conformément à l'invention, pour encoder une séquence de données $C$, cette dernière est décomposée en un ensemble de vecteurs de données comportant un nombre déterminé $N$ de vecteurs de données $C_1,...,C_N$. Le nombre de bits de la séquence de données est un multiple du nombre déterminé $N$ de vecteurs de données de sorte que tous les vecteurs de données comportent le même nombre de bits. Cette décomposition peut être réalisée par blocs ou de manière alternée ou d'une toute autre manière.

Ensuite, on détermine les vecteurs de parité $P_i$ correspondant aux vecteurs de données $C_i$ respectant l'ensemble des équations de parité $Hx^T = 0^T$ définis par la matrice de contrôle de parité $H$, sachant que $x^T$ correspond au transposé du mot de code $x$ formé des vecteurs de données $C_i$ et de parité $P_i$. En particulier, l'exemple de la matrice de contrôle de parité $H$ décrit ci-dessus permet la détermination de deux vecteurs de parité $P_1$ et $P_2$.

Finalement, on associe l'ensemble de vecteurs de données $C_1,...,C_N$ avec les vecteurs de parité $P_1$ et $P_2$ pour former un mot de code x comportant une pluralité de bits de données et une pluralité de bits de parités.

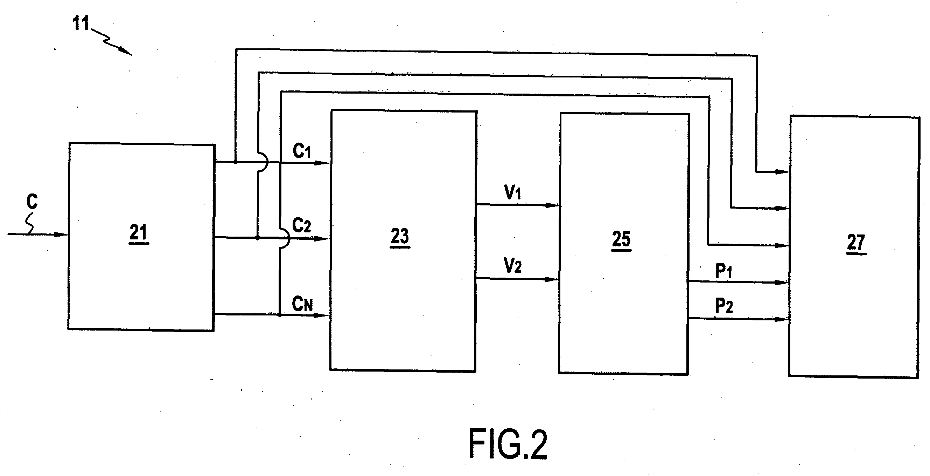

En effet, la figure 2 montre de manière schématique un dispositif d'encodage 11 d'une séquence de données comportant un moyen de décomposition 21, un moyen de transformation 23, un moyen de codage 25 et un moyen d'association 27.

Le moyen de décomposition 21 est destiné à décomposer la séquence de données $C$ en un ensemble de vecteurs de données $C_1,...,C_N$.

Les moyens de transformation 23 et de codage 25 sont destinés à déterminer les vecteurs de parité.

En effet, le moyen de transformation 23 est destiné à transformer par un ensemble de projections en parallèle l'ensemble de vecteurs de données $C_1,...,C_N$ en un ensemble de vecteurs de projection, plus particulièrement en deux vecteurs de projection $V_1$ et $V_2$.

Le moyen de codage 25 est destiné à multiplier chacun des vecteurs de projection $V_1$ et $V_2$ par l'inverse d'une matrice triangulaire $H_p$ de la matrice de contrôle de parité $H$ pour former en particulier les deux vecteurs de parité $P_1$ et $P_2$.

Finalement le moyen d'association 27 est destiné à associer l'ensemble de vecteurs de données $C_1,...,C_N$ avec les vecteurs de parité $P_1$ et $P_2$ pour former le mot de code x.

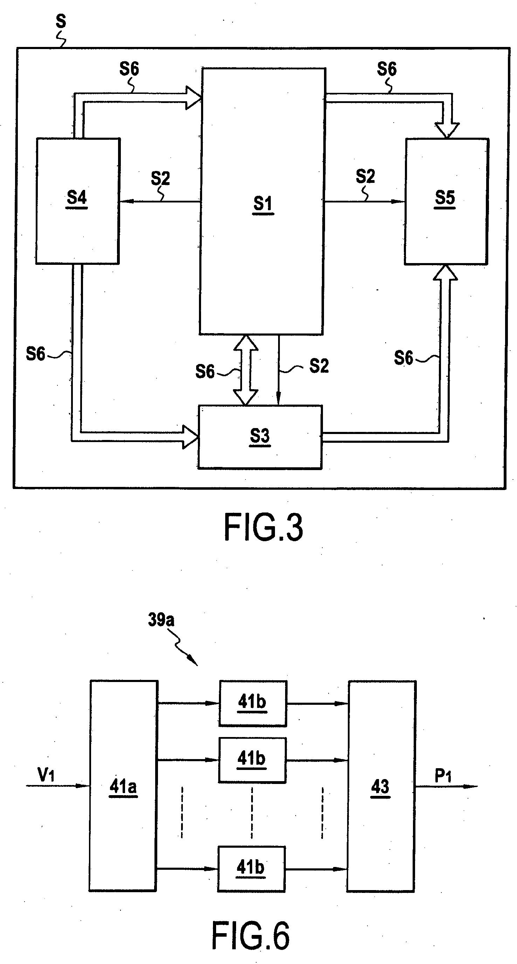

On notera que le dispositif d'encodage 11 peut être mis en oeuvre par un système informatique S (voir figure 3) comportant de manière classique une unité centrale de traitement S1 commandant par des signaux S2 une mémoire S3, une unité d'entrée S4 et une unité de sortie S5. Tous les éléments S1, S3, S4 et S5 sont raccordés entre eux par des bus de données S6. De plus, ce système informatique peut être utilisé pour exécuter un programme d'ordinateur comportant des instructions pour la mise en oeuvre du procédé d'encodage selon l'invention.

A titre d'exemple, dans le cas où la séquence de données est décomposée en seulement deux vecteurs de données (des premier et second vecteurs de données $C_1$ et $C_2$), la matrice de contrôle de parité $H$ comporte alors des première et seconde matrices de traitement $H_1$ et $H_2$, des première et seconde matrices de liaison $A_1$ et $A_2$ et deux matrices triangulaires $H_p$ disposées de la manière suivante :

$$H = \begin{bmatrix} H_1 & A_2 & H_p & 0 \\ A_1 & H_2 & 0 & H_p \end{bmatrix}$$

Cette matrice de contrôle de parité H permet de calculer les premier et second vecteurs de parité $P_1$ et $P_2$ associés aux premier et second vecteurs de données $C_1$ et $C_2$ formant ainsi un mot de code

$$x = (C_1, C_2, P_1, P_2).$$

En effet, en calculant les solutions des équations $Hx=0$, on obtient les deux vecteurs de parité $P_1$ et $P_2$ définissant le mot de code x. Plus précisément, les premier et second vecteurs de parité $P_1$ et $P_2$ peuvent être calculés selon les équations ci-dessous en trois étapes :

$$P_1^T = H_p^{-1} \cdot \left( H_1 \cdot C_1^T + A_2 \cdot C_2^T \right)$$

$$P_2^T = H_p^{-1} \cdot \left( H_2 \cdot C_2^T + A_1 \cdot C_1^T \right)$$

La première étape consiste à réaliser des première et seconde opérations de traitement et des première et seconde opérations de permutation sur les deux vecteurs de données $C_1$ et $C_2$.

Ainsi, la première opération de traitement consiste à multiplier le premier vecteur de données $C_1$ par la première matrice de traitement $H_1$ pour former un premier vecteur de contrôle $H_1 \cdot C_1^T$. De même et en parallèle la seconde opération de traitement consiste à multiplier le second vecteur de données $C_2$ par la seconde matrice de traitement $H_2$ pour former un second vecteur de contrôle $H_2 \cdot C_2^T$.

La première opération de permutation consiste à permuter le premier vecteur de données $C_1$ par la première matrice de liaison $A_1$ pour former un premier vecteur de permutation $A_1 \cdot C_1^T$. De même, la seconde opération de permutation consiste à permuter le second vecteur de données $C_2$ par la seconde matrice de liaison $A_2$ pour former un second vecteur de permutation $A_2 \cdot C_2^T$.

La seconde étape consiste d'une part à additionner le premier vecteur de contrôle $H_1 \cdot C_1^T$ en sortie de la première opération de traitement au second vecteur de permutation $A_2 \cdot C_2^T$ en sortie de la seconde opération de permutation pour former un premier vecteur de projection $V_1$ et d'autre part à additionner le second vecteur de contrôle $H_2 \cdot C_2^T$ en sortie de la seconde opération de traitement au premier vecteur de permutation $A_1 \cdot C_1^T$ en sortie de la première opération de permutation pour former un second vecteur de projection $V_2$.

La troisième étape consiste à multiplier chacun des premier et second vecteurs de projections $V_1$ et $V_2$ par l'inverse d'une matrice triangulaire $H_p^{-1}$ pour former en particulier les deux vecteurs de parité

$$P_1 = H_p^{-1} V_1^T \quad \text{et} \quad P_2 = H_p^{-1} V_2^T.$$

A titre d'exemple, la figure 4A montre que cette matrice triangulaire associée aux bits de parité est avantageusement une matrice bi-diagonale composée de deux diagonales de "1" espacées par n diagonales de "0" de la forme suivante:

$$H_p = \begin{bmatrix} 1 & & & & & & \\ 0 & 1 & & & & & \\ \vdots & 0 & 1 & & & & \\ 0 & & 0 & 1 & & & \\ 1 & 0 & & 0 & 1 & & \\ 0 & 1 & \ddots & & \ddots & \ddots & \\ \vdots & & \ddots & 0 & & 0 & 1 \\ 0 & \cdots & 0 & 1 & 0 & \cdots & 0 & 1 \end{bmatrix}$$

Les traits obliques de la figure 4A représentent les diagonales de "1", le reste de la matrice étant égal à "0". Cette matrice $H_p$ est inversible et son inverse est représenté sur la figure 4B.

Ce type de matrice a une forme remarquable qui permet un calcul rapide des bits de parité $p_j$ d'un vecteur de parité $P_i$ et qui est facile à mettre en oeuvre (voir figure 6). En effet, les bits de parité $p_j$ sont calculés à partir d'une somme cumulée des éléments $v_j$ d'un vecteur de projection $V_i$ de la manière suivante:

$$p_j = \begin{cases} v_j & 1 \le j \le n+1 \\ v_j + p_{j-(n+1)} & j > n+1 \end{cases}$$

La construction bi diagonale permet également une flexibilité de rendement par poinçonnage. Les codes LDPC en général se comportent très mal une fois poinçonnés. Le fait de poinçonner le code a pour conséquence d'ajouter des inconnues dans les équations de parités. Ainsi si une équation de parité a plus d'un terme inconnu, elle ne peut être résolue. Les matrices bi diagonales permettent un poinçonnage efficace sans perte excessive de performance. Ainsi, il est important de poinçonner les bits de parité de façon à ce qu'au maximum une seule des variables de l'équation soit inconnue. A titre d'exemple si $n=0$, un poinçonnage efficace consiste à effacer un bit de parité sur deux.

Le poinçonnage P1 peut être réalisé en poinçonnant un bit de parité sur deux ou de manière aléatoire. D'une manière générale, un poinçonnage structuré et convenablement choisit permet d'augmenter la performance du code.

La figure 5 montre un exemple particulier d'un dispositif d'encodage 11 dans lequel le nombre déterminé de vecteurs de données est égal à deux. Ce dispositif réalise ainsi les trois étapes ci-dessus et montre de manière schématique que le moyen de transformation comporte des moyens de contrôle 31a et 31b, des moyens de permutation 33a et 33b et des moyens d'addition 35a et 35b. De plus, les différents moyens de décomposition 21, de contrôle 31a, 31b, de permutation 33a, 33b, d'addition 35a, 35b et d'association 27 sont organisés selon deux branches parallèles 37a et 37b.

Ainsi, selon cet exemple, la séquence de données $C$ est décomposée par le moyen de décomposition 21 en les premier et second vecteurs de données $C_1$ et $C_2$ divergeant respectivement dans les première et seconde branches parallèles 37a et 37b.

Les moyens de contrôle 31a, 31b et de permutation 33a, 33b sont destinés à réaliser des opérations en parallèle comportant des opérations de contrôle et de permutation sur les premier et second vecteurs de données $C_1$ et $C_2$ pour former les premier et second vecteurs de contrôle $H_1C_1$ et $H_2C_2$ et les premier et second vecteurs de permutation $A_1C_1$ et $A_2C_2$.

En effet, les moyens de contrôle 31a, 31b, réalisant des opérations de contrôle, sont destinés à multiplier en parallèle sur les deux branches 37a et 37b, chacun des premier et second vecteurs de données $C_1$ et $C_2$ par une matrice de traitement de la matrice de contrôle de parité pour former les premier et second vecteurs de contrôle $H_1C_1$ et $H_2C_2$ respectivement.

En outre, les moyens de permutation 33a, 33b, réalisant des opérations de permutation, sont destinés à multiplier en parallèle sur les deux branches 37a et 37b, chacun des premier et second vecteurs de données $C_1$ et $C_2$ par une matrice de liaison de la matrice de contrôle de parité pour former lés premier et second vecteurs de permutation $A_1C_1$ et $A_2C_2$ respectivement.

Les moyens d'addition 35a, 35b sont destinés à additionner les deux vecteurs de contrôle $H_1C_1$ et $H_2C_2$ aux deux vecteurs de permutation $A_2C_2$ et $A_1C_1$ pour former les deux vecteurs de projection $V_1$ et $V_2$ de telle sorte qu'un vecteur de contrôle $H_1C_1$ en sortie d'un moyen de contrôle 31a agissant sur un vecteur de données $C_1$ est additionné à un vecteur de permutation $A_2C_2$ en sortie d'un moyen de permutation 33b agissant sur l'autre vecteur de données $C_2$. Autrement dit, le premier vecteur de projection $V_1$ est le résultat d'une addition entre le premier vecteur de contrôle $H_1C_1$ et le second vecteur de permutation $A_2C_2$ et le second vecteur de projection $V_2$ est le résultat d'une addition entre le second vecteur de contrôle $H_2C_2$ et le premier vecteur de permutation $A_1C_1$. Ainsi, chacun des vecteurs de contrôle et de permutation est utilisé une seule fois.

Le moyen de codage 25 comporte des premier et second codages différentiels 39a et 39b destinés à multiplier chacun des premier et second vecteurs de projections $V_1$ et $V_2$ par l'inverse d'une matrice bi-diagonale $H_p$ pour former les premier et second vecteurs de parité $P_1$ et $P_2$.

La figure 6 montre que chacun des premier et second codages différentiels 39a et 39b peut comporter un convertisseur série parallèle 41a, et $n+1$ codeurs différentiels 41b ($n$ étant l'espace entre les deux diagonales de "1" de la matrice bi-diagonale) et d'un convertisseur parallèle série 43 permettant ainsi de calculer de manière simple les bits de parité $p_j$ d'un vecteur de parité à partir d'une somme cumulée des éléments $v_j$ d'un vecteur de projection $V_i$.

Finalement, le moyen d'association 27 est destiné à associer les premier et second vecteurs de données $C_1$ et $C_2$ aux premier et second vecteurs de parité $P_1$ et $P_2$ pour former le mot de code x.

Ainsi, cet exemple montre bien que par exemple à chaque coup d'horloge deux bits de parités sont calculés en même temps au lieu d'un bit pour les structures classiques.

Un choix judicieux de la matrice de liaison $A$ permet de réduire d'avantage l'espace mémoire nécessaire.

La figure 7 montre une variante du dispositif d'encodage de la figure 5 permettant de réduire significativement la complexité à l'encodage tout en réalisant de très bonnes performances.

En effet, selon cet exemple, la matrice de contrôle de parité $H$ possède la structure suivante :

$$H = \begin{bmatrix} H_1 & A & H_p & 0 \\ A & H_2 & 0 & H_p \end{bmatrix}$$

Les matrices de traitement $H_1$ et $H_2$ peuvent être des matrices de la famille des Pi-rotation proposées par R.Echard et S-C Chang dans leur publication "The pi rotation Low Density Parity Check Codes", (GLOBECOM 2001, novembre 2001, pp. 980-984). Ainsi, une matrice de traitement $H_1$ peut être une matrice $H_\pi$ ayant la forme suivante :

$$H_\pi = \begin{bmatrix} \pi_A & \pi_B & \pi_C & \pi_D \\ \pi_B & \pi_C & \pi_D & \pi_A \\ \pi_C & \pi_D & \pi_A & \pi_B \\ \pi_D & \pi_A & \pi_B & \pi_C \end{bmatrix}$$

$\pi_B$, $\pi_C$, et $\pi_D$ sont directement obtenues par rotation de la matrice $\pi_A$. La matrice $\pi_B$ est obtenue par rotation de 90° de $\pi_A$ dans le sens trigonométrique. La matrice $\pi_C$ est obtenue par une rotation dans le sens trigonométrique de $\pi_B$ de 90° etc. La matrice $\pi_A$ est définie par un vecteur donnant la position des "1" dans chaque colonne. Par exemple on peut construire $H_\pi$ à partir du vecteur $v$=[1 3 2] indexant la position du "1" dans chaque colonne, en partant du bas, les sous matrices sont donc :

$$\pi_A = \begin{bmatrix} 0 & 1 & 0 \\ 0 & 0 & 1 \\ 1 & 0 & 0 \end{bmatrix} \quad \pi_D = \begin{bmatrix} 1 & 0 & 0 \\ 0 & 0 & 1 \\ 0 & 1 & 0 \end{bmatrix}$$

$$\pi_B = \begin{bmatrix} 0 & 1 & 0 \\ 1 & 0 & 0 \\ 0 & 0 & 1 \end{bmatrix} \quad \pi_C = \begin{bmatrix} 0 & 0 & 1 \\ 1 & 0 & 0 \\ 0 & 1 & 0 \end{bmatrix}$$

Il en résulte que le simple fait de connaître $\pi_A$ permet de reconstruire toute la matrice $H_\pi$.

En outre, la matrice triangulaire $H_p$ peut être choisie bi diagonale avec le paramètre $n$ égal à zéro, c'est-à-dire de la forme :

$$H_p = \begin{bmatrix} 1 & & & & \\ 1 & 1 & & & \\ & \ddots & \ddots & & \\ & & & 1 & 1 \\ & & & & 1 & 1 \end{bmatrix}$$

Enfin on peut utiliser des matrices de liaison identité A=$I$ pour obtenir le schéma d'encodage le plus simple possible. Le calcul des bits de parités se déroule alors suivant les équations suivantes :

$$P_1^T = H_p^{-1}.\left(H_1.C_1^T + C_2^T\right)$$

$$P_2^T = H_p^{-1}.\left(H_2.C_2^T + C_1^T\right)$$

Ces deux équations sont réalisées par les deux branches parallèles 37a et 37b du dispositif d'encodage.

On notera que les matrices de la famille des Pi-rotation simplifient au maximum le calcul des produits $H_1.C_1^T$ et $H_2.C_2^T$ et permettent de réduire l'espace de stockage des matrices.

Ainsi, on peut paramétrer le code en utilisant le vecteur [m,a,b,c,d], $m$ correspond à la taille de la sous matrice génératrice $\pi_A$, [a,b] aux paramètres de la matrice Pi-rotation $H_1$ et [c,d] aux paramètres de la matrice Pi-rotation $H_2$. La taille des sous matrices étant fixée le paramètre $m$ relatif à la taille de la sous matrice génératrice $\pi_A$ en est déduit directement.

Afin d'obtenir un bon code on peut alors utiliser l'algorithme suivant:

Etape 1 : Recherche de l'ensemble $C_4$ des couples [a,b] et [c,d] tel que le graphe défini par les matrices de contrôle de parité $H$=└$H_1$ $H_p$┘et $H$=└$H_2$ $H_p$┘ n'ont pas de cycles courts et plus particulièrement les cycles d'ordre 4. Pour cela on utilise par exemple un algorithme de recherche de code sans cycle d'ordre 4.

Etape 2 : Recherche de l'ensemble $C_{44}$ des quadruplets [a,b,c,d] dont les couples [a,b] et [c,d] sont inclus dans $C_4$, et tels que le graphe défini par la ma-

trice:

$$\begin{bmatrix} H_1 & I \\ I & H_2 \end{bmatrix}$$

n'ait pas de cycles courts et plus particulièrement de cycles d'ordre 4. Pour cela on utilise par exemple l'algorithme de recherche de code sans cycle d'ordre 4.

Etape 3 : Recherche parmi les quadruplets de $C_{44}$, de ceux qui maximisent la distance minimale du code associé à la matrice de contrôle de parité. Pour cela on utilise par exemple l'algorithme de recherche de distance minimale présenté dans la publication de Xiao-Yu Hu et al. intitulée "On the computation of the minimum distance of low-density parity-check codes", (ICC 2004 - IEEE International Conference on Communications, vol. 27, no. 1, juin 2004, pp. 767 - 771).

La taille du mot d'information est par exemple fixée à 60 octets. Le rendement minimum est fixé à 0.5. La taille maximum du bloc est donc de 120 octets soit 960 bits ; $H_p$ est de taille 480×480 ; $H_1$ et $H_2$ de taille 240x240.

En appliquant la technique de poinçonnage, il est possible de couvrir un très grand nombre de rendements allant de 0.5 jusqu'à 0.67. Le paramètre $m$ est donc fixé à 60 (960 = 2 x 8 x m). Ainsi, en utilisant l'algorithme présenté ci-dessus on peut obtenir un code dont les paramètres sont donnés par [a=13,b=14,c=59,d=52].

On rappelle que l'avantage de cette construction est l'encodage simple et rapide au niveau de la première entité 3 (l'émettrice) permettant une augmentation du débit d'information.

L'extension de la structure qui permet aussi une augmentation du rendement offre moins de pertes. Cependant l'extension augmente la complexité d'encodage et de décodage. Une technique basée à la fois sur du poinçonnage et sur l'extension de la structure est le meilleur compromis entre performance et complexité.

D'une manière générale, lorsque le nombre déterminé de vecteurs de données est supérieur à deux, le procédé d'encodage comporte la formation d'un ensemble de vecteurs de contrôle et d'un ensemble de vecteurs de permutation. Dans ce cas, l'ensemble de vecteurs de contrôle est additionné à l'ensemble de vecteurs de permutation pour former un ensemble de vecteurs de projection.

Ensuite, les vecteurs de projection de cet ensemble de vecteurs de projection sont additionnés deux-à-deux pour former un autre ensemble de vecteurs de projections. On notera que chaque addition entre deux vecteurs de projection est réalisée entre des vecteurs de projection ne dépendant pas des mêmes vecteurs de données.

En outre, si cet autre ensemble de vecteurs de projection comporte toujours plus que deux vecteurs de projection, alors on recommence l'addition deux-à-deux des vecteurs de projection de cet autre ensemble de vecteurs de projection de manière itérative jusqu'à l'obtention des deux vecteurs de projection.

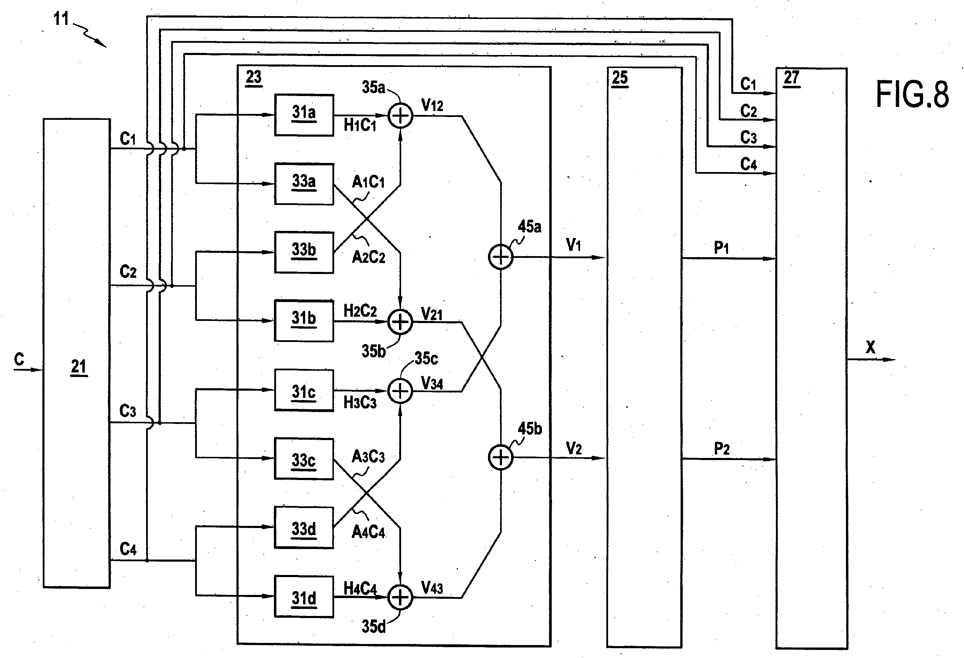

En effet, la figure 8 montre un autre exemple d'un dispositif d'encodage 11 dans lequel le nombre déterminé dé vecteurs de données est égal à quatre (c'est-à-dire un premier vecteur de données $C_1$, un deuxième vecteur de données $C_2$, un troisième vecteur de données $C_3$ et un quatrième vecteur de données $C_4$). Dans ce cas, les équations de parité sont données par la résolution de l'équation matricielle suivante :

$$\begin{bmatrix} A_1 & H_2 & A_3 & H_4 & H_p & 0 \\ H_1 & A_2 & H_3 & A_4 & 0 & H_p \end{bmatrix} \begin{bmatrix} C_1 \\ C_2 \\ C_3 \\ C_4 \\ P_1 \\ P_2 \end{bmatrix} = 0$$

Cet exemple montre que le moyen de transformation 23 du dispositif encodeur comporte des moyens de contrôles 31a à 31d, des moyens de permutation 33a à 33d, des premiers moyens d'addition 35a à 35d, et des seconds moyens d'addition 45a et 45b.

Les moyens de contrôles 31a à 31d, réalisant des opérations de contrôle, sont destinés à multiplier en parallèle chaque vecteur de données $C_i$ par une matrice de traitement $H_p$ de la matrice de contrôle de parité pour former un ensemble de vecteurs de contrôle (c'est-à-dire un premier vecteur de contrôle $H_1C_1$, un deuxième vecteur de contrôle $H_2C_2$, un troisième vecteur de contrôle $H_3C_3$ et un quatrième vecteur de contrôle $H_4C_4$).

Les moyens de permutation 33a à 33d, réalisant des opérations de permutation, sont destinés à multiplier en parallèle chaque vecteur de données $C_i$ par une matrice de liaison $A_i$ de la matrice de contrôle de parité H pour former un ensemble de vecteurs de permutation (c'est-à-dire un premier vecteur de permutation $A_1C_1$, un deuxième vecteur de permutation $A_2C_2$, un troisième vecteur de permutation $A_3C_3$ et un quatrième vecteur de permutation $A_4C_4$).

Les premiers moyens d'addition 35a à 35d sont destinés à additionner l'ensemble de vecteurs de contrôle à l'ensemble de vecteurs de permutation pour former un ensemble de vecteurs de projection de telle sorte qu'un vecteur de contrôle en sortie d'un moyen de contrôle agissant sur un vecteur de données quelconque est additionné à un vecteur de permutation en sortie d'un moyen de permutation agissant sur un autre vecteur de données. On notera que lors de la formation de l'ensemble de vecteurs de projection, chaque: vecteur de permutation de l'ensemble de vecteurs de permutations est utilisé de manière unique.

Autrement dit, le premier vecteur de contrôle $H_1C_1$ est additionné avec le deuxième vecteur de permutation $A_2C_2$ pour former un premier vecteur de projection vu dépendant des premier et deuxième vecteurs de données. Le deuxième vecteur de contrôle $H_2C_2$ est additionné avec le premier vecteur de permutation $A_1C_1$ pour former un deuxième vecteur de projection $V_{21}$ dépendant des premier et deuxième vecteurs de données. Le troisième vecteur de contrôle $H_3C_3$ est additionné avec le quatrième vecteur de permutation $A_4C_4$ pour former un troisième vecteur de projection $V_{34}$ dépendant des troisième et quatrième vecteurs de données. Finalement, le quatrième vecteur de contrôle $H_4C_4$ est additionné avec le troisième vecteur de permutation $A_3C_3$ pour former un quatrième vecteur de projection $V_{43}$ dépendant des troisième et quatrième vecteurs de données.

Enfin, les seconds moyens d'addition 45a et 45b additionnent le premier vecteur de projection $V_{12}$ avec le troisième vecteur de projection $V_{34}$ et le deuxième vecteur de projection $V_{21}$ avec le quatrième vecteur de projection $V_{43}$ pour former uniquement les deux vecteurs de projection $V_1$ et $V_2$ qui vont être utilisés par le moyen de codage 25 pour former les deux vecteurs de parité $P_1$ et $P_2$.

Bien entendu, lorsque le nombre déterminé de vecteurs de données est supérieur à quatre, d'autres seconds moyens d'addition additionnent de manière successive deux-à-deux les vecteurs de projection de l'ensemble de vecteurs de projection jusqu'à l'obtention de seulement deux vecteurs de projection.

Ainsi, le dispositif d'encodage selon l'invention, réalise la détermination des vecteurs de parité respectant les équations de parité définies par la matrice de contrôle de parité.

En particulier, un programme d'ordinateur comportant des instructions nécessaires à la réalisation du procédé d'encodage peut être mise en oeuvre dans les moyens de décomposition et/ou de transformation et/ou de codage et/ou d'association du dispositif d'encodage.

Conformément à l'invention, la figure 9 montre un dispositif de décodage 13 d'un signal codé de réception S7 comportant des bits codés. Ce signal codé de réception S7 est issu d'un ensemble de mots de code construit selon la matrice de contrôle de parité $H$.

Le dispositif de décodage 13 comporte des moyens de traitement 41, connectés à des modules 43 de contrôle de parité par des premier et second moyens de bouclage 45a et 45b. Le premier moyen de bouclage 45a réalise une fonction de permutation et le second moyen de bouclage 45b réalise une fonction de permutation inverse permettant ainsi la propagation d'information entre les moyens de traitement 41 et les modules 43 de contrôle de parité de manière itérative.

Les moyens de traitement 41 reçoivent les valeurs des bits codés constituant le signal codé de réception S7. En effet, ces moyens de traitement 41 sont destinés à résoudre les équations de parité associées à la matrice de contrôle de parité pour calculer des estimations probabilistes sur les valeurs des bits codés participant à chacune de ces équations de parité.

On notera que, la résolution des équations de parité permet d'établir des relations entre ces équations de parité et les bits codés sous la forme d'un graphe de Tanner. Ainsi, le décodage peut être réalisée de manière itérative en propageant des messages entre différents niveaux d'un arbre formé par le processus d'itération agissant sur te graphe de Tanner.

En effet, les estimations probabilistes calculées par les moyens de traitement 41 sont envoyées aux modules 43 de contrôle de parité à travers le premier moyen de bouclage 45a.

Chacun des modules 43 de contrôle de parité traite de manière itérative les bits codés, et communique avec les autres modules 43 pour échanger les messages ou estimations probabilistes permettant ainsi aux moyens de traitement 41 de calculer à chaque itération et pour chaque bit codé une nouvelle estimation probabiliste et à mettre à jour les estimations probabilistes au niveau des équations de parité jusqu'à ce qu'une condition d'arrêt prédéterminée soit respectée.

Lorsque la condition d'arrêt est respectée, les moyens de traitement 41 émettent un signal comportant les mots de code estimés. On notera que cette condition d'arrêt peut être définie par un nombre déterminé d'itérations et/ou par une convergence du décodage vers un mot de code.

On notera que le dispositif de décodage 13 peut être mis en oeuvre par un système informatique S comme celui de la figure 3. De plus, ce système informatique peut être utilisé pour exécuter un programme d'ordinateur comportant des instructions pour la mise en oeuvre du procédé de décodage selon l'invention.

A titre d'exemple, l'algorithme de décodage peut être décomposé de manière itérative en trois étapes.

La première étape concerne la résolution des équations de parité. En effet, chaque ligne de la matrice de contrôle de parité $H$ définie une équation de parité tel que $H.\tilde{c}^T=0$, où $\tilde{c}$ sont les estimations pondérées reçues au décodeur. La résolution de chaque équation donne une information sur les variables participant à celle-ci. Les variables participant à l'équation de parité $i$ sont données par les éléments non nuls de $H(i,j)$, où $H(i,j)$ est l'élément de la i ième ligne et j ième colonne de la matrice de contrôle de parité $H$. La résolution de la $i$ ième ligne permet le calcul des messages $m_{i,j}$ envoyés à l'ensemble des variables connectées à cette équation de la façon suivante:

$$m_{i,j} = 2\tanh^{-1} \prod_{n \in W/j} \tanh\left(\frac{v_{n,j}}{2}\right)$$

où $v_{n,j}$ représente le message de la variable n à l'équation de contrôle de parité $i$.

La deuxième étape de l'algorithme consiste pour chaque variable $j$ à collecter les informations provenant des différentes équations de contrôle de parité. La valeur à posteriori de chaque variable est égale à la somme de tous les messages provenant des différentes équations de parités. L'ensemble des équations de parité $E$ faisant intervenir la variable $j$ est donnée par les éléments non nul de $H(i,j)$. Cette somme est égale à:

$$v_j = u_j^0 + \sum_{n \in E_j} m_{n,j}$$

Où $u_j^0$ est le rapport de vraisemblance de la variable $j$ observé en sortie de canal. En utilisant cette valeur à posteriori $v_j$, une décision sur la valeur binaire de chaque variable est prise:

$$\bar{v}_j = \frac{1 - sign(v_j)}{2}$$

en considérant une mise en constellation de la forme $0 \rightarrow 1$ et $1 \rightarrow -1$.

La troisième étape consiste à calculer les messages envoyés à chaque équation de parité où intervient cette variable. Chaque message $v_{j,i}$ de la variable $j$ vers l'équation $i$ est calculé en utilisant la relation suivante:

$$v_{j,i} = v_j - m_{i,j}$$

Ces trois étapes sont répétées jusqu'à ce que la condition d'arrêt soit respectée. C'est-à-dire, le nombre d'itération maximum est atteint ou le décodage a convergé vers un mot de code et la relation $H \cdot c^T = 0$ est vérifiée.

On notera que le décodage des codes LDPC peut être également effectué par d'autres algorithmes itératifs basés sur des approximations de l'algorithme ci-dessus, par exemple le BP-based algorithm (ou min-sum algorithm), l'APP algorithm, l'APP-based algorithm, le À-min algorithm, A-min* algorithm etc.

Ainsi, la structure de la matrice de contrôle de parité de l'invention permet un encodage simple et rapide grâce à la parallélisation des calculs et permet aussi un décodage simple. De plus, en terme de performances, le code ainsi construit permet des performances en terme de taux d'erreur binaire comparables voir supérieures à d'autres codes LDPC classiques. Enfin il faut noter la flexibilité en terme de taille et de rendement offerte cette construction.

**Revendications**

1. Procédé d'encodage d'une séquence de données en un mot de code x suivant un code LDPC correspondant à une matrice de contrôle de parité H, dans lequel :

- chaque colonne de ladite matrice de contrôle de parité H définit un nombre déterminé de bits codés formant le mot de code x, ledit mot de code comprenant des bits de données et des bits de parité, lesdits bits de données étant décomposés en un ensemble de vecteurs de données ($C_1, \ldots, C_i$) avec i≥2, chaque vecteur de données comportant le même nombre de bits, lesdits bits de parité correspondant à deux vecteurs de parité $P_1$ et $P_2$;
- chaque ligne de ladite matrice de contrôle de parité H définit une équation de parité,
- ladite matrice de contrôle de parité H est constituée de deux lignes matricielles, chaque élément d'une ligne matricielle étant une matrice, et chaque ligne matricielle comprenant au moins une matrice dite de traitement et une matrice dite de liaison comportant un unique « 1 » par colonne et un unique « 1 » par ligne, une matrice nulle 0 et une matrice triangulaire $H_p$,

lesdites matrices étant disposées de la manière suivante sur une des lignes matricielles :

$$H_1 \quad A_2 \quad \ldots \quad H_{i-1} \quad A_i \quad H_p \quad 0$$

et pour i=2 selon :

$$H_1 \quad A_2 \quad H_p \quad 0$$

et de la manière suivante sur l'autre ligne matricielle :

$$A_1 \quad H_2 \quad \ldots \quad A_{i-1} \quad H_i \quad 0 \quad H_p$$

et pour i=2 selon :

$$A_1 \quad H_2 \quad 0 \quad H_p$$

$A_1, \ldots, A_i$ désignant les matrices de liaison et $H_1, \ldots, H_i$ désignant les matrices de traitement,
les matrices de traitement et de liaison formant un bloc correspondant aux bits de données et les matrices nulles et triangulaires formant un autre bloc correspondant aux bits de parité,
les vecteurs de parité $P_1$ et $P_2$ respectant l'ensemble des équations de parité définies par la matrice de contrôle de parité H et par la relation $Hx^T=0^T$ où $^T$ désigne l'opérateur de transposition, et pouvant être calculés selon les équations suivantes :

$$P_1^T = H_P^{-1}(H_1 C_1^T + \dots + A_i C_i^T)$$

$$P_2^T = H_P^{-1}(A_1 C_1^T + \dots + H_i C_i^T).$$

2.  Procédé d'encodage selon la revendication 1, comportant les étapes suivantes :

    - décomposer la séquence de données en ledit ensemble de vecteurs de données $(C_1,\dots,C_i)$ ledit ensemble comportant un nombre déterminé de vecteurs de données,
    - détermination, en utilisant la matrice de contrôle de parité H, des vecteurs de parité $P_1$ et $P_2$ correspondant aux vecteurs de données $(C_1,\dots,C_i)$ et respectant l'ensemble des équations de parité définies par ladite matrice de contrôle de parité H et par la relation $Hx^T=0^T$ où $^T$ désigne l'opérateur de transposition, et
    - associer l'ensemble de vecteurs de données avec les vecteurs de parité pour former un mot de code comportant une pluralité de bits de données et une pluralité de bits de parité.

3.  Procédé d'encodage selon la revendication 2 comportant les étapes suivantes :

    - transformer par un ensemble de projections en parallèle ledit ensemble de vecteurs de données en deux vecteurs de projection,
    - multiplier chacun des vecteurs de projection par l'inverse de la matrice triangulaire $H_p$ de ladite matrice de contrôle de parité pour former lesdits vecteurs de parité $P_1$ et $P_2$ ;

    et dans lequel :

    - le nombre déterminé de vecteurs de données $C_1$, $C_2$ est égal à deux,
    - l'étape de transformation par projections en parallèle comporte les étapes suivantes :

        réaliser des opérations en parallèle comportant des opérations de contrôle et de permutation sur lesdits deux vecteurs de données pour former deux vecteurs de contrôle et deux vecteurs de permutation, lesdites opérations de contrôle comportant la multiplication du vecteur de données $C_1^T$ par la matrice de traitement $H_1$ de la matrice de contrôle de parité H et la multiplication du vecteur de données $C_2^T$ par la matrice de traitement $H_2$ de la matrice de contrôle de parité H, et lesdites opérations de permutation comportant la multiplication du vecteur de données $C_1^T$ par la matrice de liaison $A_1$ de ladite matrice de contrôle de parité et la multiplication du vecteur de données $C_2^T$ par la matrice de liaison $A_2$ de ladite matrice de contrôle de parité ; et
additionner lesdits deux vecteurs de contrôle auxdits deux vecteurs de permutation pour former un ensemble de vecteurs de projection constitué desdits deux vecteurs de projection de telle sorte qu'un vecteur de contrôle en sortie d'une opération de contrôle sur un vecteur de données est additionné à un vecteur de permutation en sortie d'une opération de permutation sur l'autre vecteur de données.

4.  Procédé selon la revendication 2 comportant les étapes suivantes :

    - transformer par un ensemble de projections en parallèle ledit ensemble de vecteurs de données en deux vecteurs de projection,
    - multiplier chacun des vecteurs de projection par l'inverse de la matrice triangulaire Hp de ladite matrice de contrôle de parité pour former lesdits vecteurs de parité $P_1$ et $P_2$ ;

    et dans lequel :

    - le nombre déterminé de vecteurs de données $C_1,\dots,C_i$ est supérieur à deux,
    - l'étape de transformation par projections en parallèle comporte les étapes suivantes :

        réaliser des opérations en parallèle comportant des opérations de contrôle et de permutation sur ledit ensemble de vecteurs de données pour former un ensemble de vecteurs de contrôle et un ensemble de vecteurs de permutation, lesdites opérations de contrôle comportant la multiplication de chaque vecteur de données $C_j^T$, j=1,...,i par la matrice de traitement $H_j$, j=1,...,i de la matrice de contrôle de parité et lesdites opérations de permutation comportant la multiplication de chaque vecteur de données $C_j^T$, j=1,...,i par la matrice de liaison $A_j$, j=1,...,i de la matrice de contrôle de parité ; additionner ledit ensemble de vecteurs de contrôle audit ensemble de vecteurs de permutation pour former un ensemble de vecteurs de projection de telle sorte qu'un vecteur de contrôle en sortie d'une opération de contrôle sur un vecteur de données quelconque est additionné à un vecteur de permutation en sortie d'une opération de permutation sur un autre vecteur de données, et

additionner deux-à-deux les vecteurs de projection dudit ensemble de vecteurs de projection pour former un autre ensemble de vecteurs de projections, l'addition étant réalisée entre deux vecteurs de projection ne dépendant pas des mêmes vecteurs de données, et

si l'autre ensemble de vecteurs de projection comporte plus que deux vecteurs de projection, alors recommencer l'étape précédente jusqu'à l'obtention de deux vecteurs de projection.

5. Procédé selon l'une quelconque des revendication 3 et 4, dans lequel lors de la formation dudit ensemble de vecteurs de projection, chaque vecteur de permutation dudit ensemble de vecteurs de permutation est utilisé de manière unique.

6. Procédé selon l'une quelconque des revendications 3 et 4, dans lequel les matrices de liaison de ladite matrice de contrôle de parité sont identiques.

7. Procédé selon la revendication 6, dans lequel lesdites matrices de liaison sont des matrices identité.

8. Procédé selon la revendication 1, **caractérisé en ce que** la matrice triangulaire est une matrice bi-diagonale comportant deux diagonales de « 1 » espacées par un nombre donné n de diagonales de « 0 ».

9. Procédé selon l'une quelconque des revendications 2 à 8, comportant en outre une étape de poinçonnage des bits de parités dudit mot de code.

10. Système de communication comportant une première entité (3) comprenant une source d'information (9) et un dispositif encodeur (11), connectée via un canal (7) de transmission de données à une seconde entité (5) comportant un dispositif décodeur (13), **caractérisé en ce que** le dispositif encodeur (11) est destiné à encoder une séquence de données émise par la source d'information (9) pour former un ensemble de mots de code à partir d'une matrice de contrôle de parité H, dans laquelle :

- chaque colonne de ladite matrice de contrôle de parité définit un nombre déterminé de bits codés formant un mot de code x, ce mot de code comprenant des bits de données et des bits de parité, lesdits bits de données étant décomposés en un ensemble de vecteurs de données $(C_1,...,C_i)$ avec $i \geq 2$, chaque vecteur de données comportant le même nombre de bits, et lesdits bits de parité correspondant à deux vecteurs de parité $P_1$ et $P_2$ ;
- chaque ligne de ladite matrice de contrôle de parité H définit une équation de parité, et
- ladite matrice de contrôle de parité H est constituée de deux lignes matricielles, chaque élément d'une ligne matricielle étant une matrice et chaque ligne matricielle comprenant au moins une matrice dite de traitement, au moins une matrice dite de liaison comportant un unique « 1 » par colonne et un unique « 1 » par ligne, une matrice nulle 0 et une matrice triangulaire $H_p$, lesdites matrices étant disposées de la manière suivante sur une des lignes matricielles :

$$H_1 \quad A_2 \quad ... \quad H_{i-1} \quad A_i \quad H_p \quad 0$$

et pour i=2 selon :

$$H_1 \quad A_2 \quad H_p \quad 0$$

et de la manière suivante sur l'autre ligne matricielle :

$$A_1 \quad H_2 \quad ... \quad A_{i-1} \quad H_i \quad 0 \quad H_p$$

et pour i=2 selon :

$$A_1 \quad H_2 \quad 0 \quad H_p$$

$A_1,...,A_i$ désignant les matrices de liaison et $H_1,...,H_i$ désignant les matrices de traitement, les matrices de traitement et de liaison formant un bloc correspondant aux bits de données et les matrices nulles et triangulaires formant un autre bloc correspondant aux bits de parité, les vecteurs de parité $P_1$ et $P_2$ respectant l'ensemble des équations de parité définies par la matrice de contrôle de parité H et par la relation $H_x{}^T = 0^T$ où $^T$ désigne l'opérateur de transposition, et pouvant être calculés selon les équations suivantes :

$$P_1^T = H_P^{-1}(H_1 C_1^T + ... + A_i C_i^T)$$

$$P_2^T = H_P^{-1}(A_1 C_1^T + ... + H_i C_i^T)$$

et **en ce que** le dispositif décodeur (13) est destiné à décoder un signal codé de réception reçu par la seconde entité, ledit signal codé de réception étant issu de l'ensemble de mots de code formé à partir de ladite matrice de contrôle de parité H.

11. Dispositif d'encodage d'une séquence de données en un mot de code x suivant un code LDPC correspondant à une matrice de contrôle de parité H dans laquelle :

   - chaque colonne de ladite matrice de contrôle de parité définit un nombre déterminé de bits codés formant le mot de code x, ce mot de code comprenant des bits de données et des bits de parité, lesdits bits de données étant décomposés en un ensemble de vecteurs de données $(C_1,...,C_i)$ avec i≥2, chaque vecteur de données comportant le même nombre de bits, et lesdits bits de parité correspondant à deux vecteurs de parité $P_1$ et $P_2$ ;
   - chaque ligne de ladite matrice de contrôle de parité H définit une équation de parité, et
   - ladite matrice de contrôle de parité H est constituée de deux lignes matricielles, chaque élément d'une ligne matricielle étant une matrice et chaque ligne matricielle comprenant au moins une matrice dite de traitement, au moins une matrice dite de liaison comportant un unique « 1 » par colonne et un unique « 1 » par ligne, une matrice nulle 0 et une matrice triangulaire $H_p$, lesdites matrices étant disposées de la manière suivante sur une des lignes matricielles :

$$H_1 \quad A_2 \quad ... \quad H_{i-1} \quad A_i \quad H_p \quad 0$$

et pour i=2 selon :

$$H_1 \quad A_2 \quad H_p \quad 0$$

et de la manière suivante sur l'autre ligne matricielle :

$$A_1 \quad H_2 \quad ... \quad A_{i-1} \quad H_i \quad 0 \quad H_p$$

et pour i=2 selon :

$$A_1 \quad H_2 \quad 0 \quad H_p$$

$A_1,...,A_i$ désignant les matrices de liaison et $H_1,...,H_i$ désignant les matrices de traitement, les matrices de traitement et de liaison formant un bloc correspondant aux bits de données et les matrices nulles et triangulaires formant un autre bloc correspondant aux bits de parité, les vecteurs de parité $P_1$ et $P_2$ respectant l'ensemble des équations de parité définies par la matrice de contrôle de parité H et par la relation $Hx^T=0^T$ où $T$ désigne l'opérateur de transposition, et pouvant être calculés selon les équations suivantes :

$$P_1^T = H_P^{-1}(H_1 C_1^T + ... + A_i C_i^T)$$

$$P_2^T = H_P^{-1}(A_1 C_1^T + ... + H_i C_i^T)$$

ledit dispositif d'encodage comportant:

   - un moyen de décomposition (21) de la séquence de données en ledit ensemble de vecteurs de données $(C_1,...,C_i)$, ledit ensemble comportant un nombre déterminé de vecteurs de données,
   - un moyen de transformation (23) transformant par un ensemble de projections en parallèle ledit ensemble de vecteurs de données en vecteurs de projection,
   - un moyen de codage (25) multipliant chacun des vecteurs de projection par l'inverse de ladite matrice triangulaire $H_p$ de ladite matrice de contrôle de parité pour former lesdits deux vecteurs de parité $P_1$ et $P_2$, et
   - un moyen d'association (27) associant l'ensemble de vecteurs de données avec lesdits vecteurs de parité pour former un mot de code comportant une pluralité de bits de données et une pluralité de bits de parité ;

et dans lequel :

   - le nombre déterminé de vecteurs de données est égal à deux,
   - le moyen de transformation (23) comporte :

      des moyens de contrôle (31a, 31b) multipliant en parallèle le vecteur de données $C_1T$ par la matrice de traitement $H_1$ de la matrice de contrôle de parité H et le vecteur de données $C_2^T$ par la matrice de traitement $H_2$ de la matrice de contrôle de parité H formant deux vecteurs de contrôle,
      des moyens de permutation (33a, 33b) multipliant en parallèle le vecteur de données $C_1^T$ par la matrice de liaison $A_1$ de ladite matrice de contrôle de parité et le vecteur de données $C_2^T$ par la matrice de liaison $A_2$ de ladite matrice de contrôle de parité formant deux vecteurs de permutation, et

des moyens d'addition (35a, 35b) additionnant lesdits deux vecteurs de contrôle auxdits deux vecteurs de permutation pour former lesdits deux vecteurs de projection de telle sorte qu'un vecteur de contrôle en sortie d'un moyen de contrôle agissant sur un vecteur de données est additionné à un vecteur de permutation en sortie d'un moyen de permutation agissant sur l'autre vecteur de données.

12. Dispositif d'encodage d'une séquence de données en un mot de code x suivant un code LDPC correspondant à une matrice de contrôle de parité H dans laquelle :

- chaque colonne de ladite matrice de contrôle de parité définit un nombre déterminé de bits codés formant le mot de code x, ce mot de code comprenant des bits de données et des bits de parité, lesdits bits de données étant décomposés en un ensemble de vecteurs de données $(C_1,...,C_i)$ avec $i \geq 2$, chaque vecteur de données comportant le même nombre de bits, et lesdits bits de parité correspondant à deux vecteurs de parité $P_1$ et $P_2$;
- chaque ligne de ladite matrice de contrôle de parité H définit une équation de parité, et
- ladite matrice de contrôle de parité H est constituée de deux lignes matricielles, chaque élément d'une ligne matricielle étant une matrice et chaque ligne matricielle comprenant au moins une matrice dite de traitement, au moins une matrice dite de liaison comportant un unique « 1 » par colonne et un unique « 1 » par ligne, une matrice nulle 0 et une matrice triangulaire $H_p$, lesdites matrices étant disposées de la manière suivante sur une des lignes matricielles :

$$H_1 \quad A_2 \quad ... \quad H_{i-1} \quad A_i \quad H_p \quad 0$$

et pour i=2 selon :

$$H_1 \quad A_2 \quad H_p \quad 0$$

et de la manière suivante sur l'autre ligne matricielle :

$$A_1 \quad H_2 \quad ... \quad A_{i-1} \quad H_i \quad 0 \quad H_p$$

et pour i=2 selon :

$$A_1 \quad H_2 \quad 0 \quad H_p$$

$A_1,...,A_i$ désignant les matrices de liaison et $H_1,...,H_i$ désignant les matrices de traitement, les matrices de traitement et de liaison formant un bloc correspondant aux bits de données et les matrices nulles et triangulaires formant un autre bloc correspondant aux bits de parité, les vecteurs de parité $P_1$ et $P_2$ respectant l'ensemble des équations de parité définies par la matrice de contrôle de parité H et par la relation $Hx^T = 0^T$ où $^T$ désigne l'opérateur de transposition, et pouvant être calculés selon les équations suivantes :

$$P_1^T = H_P^{-1}(H_1 C_1^T + ... + A_i C_i^T)$$

$$P_2^T = H_P^{-1}(A_1 C_1^T + ... + H_i C_i^T)$$

ledit dispositif d'encodage comportant:

- un moyen de décomposition (21) de la séquence de données en ledit ensemble de vecteurs de données $(C_1,...,C_i)$, ledit ensemble comportant un nombre déterminé de vecteurs de données,
- un moyen de transformation (23) transformant par un ensemble de projections en parallèle ledit ensemble de vecteurs de données en vecteurs de projection,
- un moyen de codage (25) multipliant chacun des vecteurs de projection par l'inverse de ladite matrice triangulaire $H_p$ de ladite matrice de contrôle de parité pour former lesdits deux vecteurs de parité $P_1$ et $P_2$, et
- un moyen d'association (27) associant l'ensemble de vecteurs de données avec lesdits vecteurs de parité pour former un mot de code comportant une pluralité de bits de données et une pluralité de bits de parité ;

et dans lequel :

- le nombre déterminé de vecteurs de données $C_1,...,C_i$ est supérieur à deux,
- le moyen de transformation (23) comporte :

des moyens de contrôle (31a à 31d) multipliant en parallèle chaque vecteur de données $C_j^T$, j=1,...,i par chaque matrice de traitement $H_j$, j=1,...,i respectivement de ladite matrice de contrôle de parité formant un ensemble de vecteurs de contrôle, des moyens de permutation (33a à 33d) multipliant en parallèle chaque vecteur de données $C_j^T$, j=1,...,i par chaque matrice de liaison $A_j$, j=1,...,i respectivement de ladite matrice de contrôle de parité formant un ensemble de vecteurs de permutation, et
des premiers moyens d'addition (35a à 35d) additionnant ledit ensemble de vecteurs de contrôle audit ensemble de vecteurs de permutation pour former un ensemble de vecteurs de projection de telle sorte qu'un vecteur de contrôle en sortie d'un moyen de contrôle agissant sur un vecteur de données quelconque est additionné à un vecteur de permutation en sortie d'un moyen de permutation agissant sur un autre vecteur de données, et
des seconds moyens d'addition (45a, 45b) additionnant de manière successive deux-à-deux les vecteurs de projection de l'ensemble de vecteurs de projection jusqu'à l'obtention de deux vecteurs de projection.

13. Programme d'ordinateur mis en oeuvre dans un système informatique, comportant des instructions nécessaires à la réalisation du procédé d'encodage selon l'une quelconque des revendications 2 à 9.

**Patentansprüche**

1. Verfahren zum Kodieren einer Datenfolge in ein Codewort x nach einem LDPC-Code, der einer Paritätskontrollmatrix H entspricht, wobei:

- jede Spalte der Paritätskontrollmatrix H eine bestimmte Anzahl von kodierten Bits definiert, die das Codewort x bilden, wobei das Codewort Datenbits und Paritätsbits umfasst, wobei die Datenbits in eine Menge von Datenvektoren ($C_1$, ..., $C_i$) mit $i \geq 2$ zerlegt werden, wobei jeder Datenvektor die gleiche Anzahl von Bits umfasst, wobei die Paritätsbits zwei Paritätsvektoren $P_1$ und $P_2$ entsprechen;
- jede Zeile der Paritätskontrollmatrix H eine Paritätsgleichung definiert,
- die Paritätskontrollmatrix H aus zwei Matrixzeilen besteht, wobei jedes Element einer Matrixzeile eine Matrix ist, und jede Matrixzeile mindestens eine sogenannte Verarbeitungsmatrix und eine sogenannte Verbindungsmatrix, die eine einzige "1" pro Spalte und eine einzige "1" pro Zeile umfasst, eine Nullmatrix 0 und eine Dreiecksmatrix $H_p$ umfasst,

wobei die Matrizen auf einer der Matrixzeilen auf die folgende Art und Weise angeordnet sind:

$$H_1 \ A_2 \ \ldots \ H_{i-1} \ A_i \ H_p \ 0$$

und für i = 2 gemäß:

$$H_1 \ A_2 \ H_p \ 0$$

und auf die folgende Art und Weise auf der anderen Matrixzeile:

$$A_1 \ H_2 \ldots \ A_{i-1} \ H_i \ 0 \ H_p$$

und für i=2 gemäß:

$$A_1 \ H_2 \ 0 \ H_p$$

wobei $A_1$, ..., $A_i$ die Verbindungsmatrizen bezeichnen und $H_1$, ..., $H_i$ die Verarbeitungsmatrizen bezeichnen,
wobei die Verarbeitungs- und Verbindungsmatrizen einen Block bilden, der den Datenbits entspricht, und die Null- und Dreiecksmatrizen einen anderen Block bilden, der den Paritätsbits entspricht,
die Paritätsvektoren $P_1$ und $P_2$ die Menge der Paritätsgleichungen erfüllen, die durch die Paritätskontrollmatrix H und durch die Beziehung $Hx^T = 0^T$ definiert sind, wobei $^T$ den Transpositionsoperator bezeichnet, und gemäß den folgenden Gleichungen berechnet werden können:

$$P_1^T = H_P^{-1}(H_1 C_1^T + \cdots + A_i C_i^T)$$

$$P_2^T = H_P^{-1}(A_1 C_1^T + \cdots + H_i C_i^T).$$

2. Kodierungsverfahren nach Anspruch 1, das die folgenden Schritte umfasst:

- Zerlegen der Datenfolge in die Menge von Datenvektoren ($C_1$..., $C_i$), wobei die Menge eine bestimmte Anzahl von Datenvektoren umfasst,
- unter Verwendung der Paritätskontrollmatrix H, Bestimmen der Paritätsvektoren $P_1$ und $P_2$, die den Datenvektoren ($C_1$,..., $C_i$) entsprechen und die Menge der Paritätsgleichungen erfüllen, die durch die Paritätskontrollmatrix H und durch die Beziehung $Hx^T = 0^T$ definiert sind, wobei $^T$ den Transpositionsoperator bezeichnet, und
- Verknüpfen der Menge von Datenvektoren mit den Paritätsvektoren, um ein Codewort zu bilden, das mehrere Datenbits und mehrere Paritätsbits umfasst.

3. Kodierungsverfahren nach Anspruch 2, das die folgenden Schritte umfasst:

- Transformieren der Menge von Datenvektoren in zwei Projektionsvektoren durch eine Menge von Parallelprojektionen,
- Multiplizieren von jedem der Projektionsvektoren mit dem Inversen der Dreiecksmatrix $H_p$ der Paritätskontrollmatrix, um die Paritätsvektoren $P_1$ und $P_2$ zu bilden;

und wobei:

- die bestimmte Anzahl von Datenvektoren $C_1$, $C_2$ gleich zwei ist,
- der Schritt der Transformation durch Parallelprojektionen die folgenden Schritte umfasst:

paralleles Ausführen der Operationen, die die Kontroll- und Permutationsoperationen umfassen, auf den zwei Datenvektoren, um zwei Kontrollvektoren und zwei Permutationsvektoren zu bilden, wobei die Kontrolloperationen die Multiplikation des Datenvektors $C_1^T$ mit der Verarbeitungsmatrix $H_1$ der Paritätskontrollmatrix H und die Multiplikation des Datenvektors $C_2^T$ mit der Verarbeitungsmatrix $H_2$ der Paritätskontrollmatrix H umfassen und die Permutationsoperationen die Multiplikation des Datenvektors $C_1^T$ mit der Verbindungsmatrix $A_1$ der Paritätskontrollmatrix und die Multiplikation des Datenvektors $C_2^T$ mit der Verbindungsmatrix $A_2$ der Paritätskontrollmatrix umfassen; und
Addieren der zwei Kontrollvektoren zu den zwei Permutationsvektoren, um eine Menge von Projektionsvektoren zu bilden, die aus den zwei Projektionsvektoren besteht, derart, dass ein Kontrollvektor am Ausgang einer Kontrolloperation auf einem Datenvektor zu einem Permutationsvektor am Ausgang einer Permutationsoperation auf dem anderen Datenvektor addiert wird.

4. Verfahren nach Anspruch 2, das die folgenden Schritte umfasst:

- Transformieren der Menge von Datenvektoren in zwei Projektionsvektoren durch eine Menge von Parallelprojektionen,
- Multiplizieren von jedem der Projektionsvektoren mit dem Inversen der Dreiecksmatrix $H_p$ der Paritätskontrollmatrix, um die Paritätsvektoren $P_1$ und $P_2$ zu bilden;

und wobei:

- die bestimmte Anzahl von Datenvektoren $C_1$, ..., $C_i$ größer als zwei ist,
- der Schritt zur Transformation durch Parallelprojektionen die folgenden Schritte umfasst:

paralleles Ausführen der Operationen, die Kontroll- und Permutationsoperationen umfassen, auf der Menge von Datenvektoren, um eine Menge von Kontrollvektoren und eine Menge von Permutationsvektoren zu bilden, wobei die Kontrolloperationen die Multiplikation von jedem Datenvektor $C_j^T$, j=1, ..., i mit der Verarbeitungsmatrix $H_j$, j=1, ..., i der Paritätskontrollmatrix umfassen und die Permutationsoperationen die Multiplikation von jedem Datenvektor $C_j^T$, j=1, ..., i mit der Verbindungsmatrix $A_j$, j=1, ..., i der Paritätskontrollmatrix umfassen;
Addieren der Menge von Kontrollvektoren zu der Menge von Permutationsvektoren, um eine Menge von Projektionsvektoren zu bilden, derart, dass ein Kontrollvektor am Ausgang einer Kontrolloperation auf irgendeinem Datenvektor zu einem Permutationsvektor am Ausgang einer Permutationsoperation auf einem anderen Datenvektor addiert wird, und
paarweises Addieren der Projektionsvektoren der Menge von Projektionsvektoren, um eine andere Menge von Projektionsvektoren zu bilden, wobei die Addition zwischen zwei Projektionsvektoren ausgeführt wird, die nicht von den gleichen Datenvektoren abhängig sind, und

wenn die andere Menge von Projektionsvektoren mehr als zwei Projektionsvektoren umfasst, dann erneutes Beginnen des vorhergehenden Schritts, bis zwei Projektionsvektoren erhalten werden.

5. Verfahren nach einem der Ansprüche 3 und 4, wobei bei der Bildung der Menge von Projektionsvektoren jeder Permutationsvektor der Menge von Permutationsvektoren auf eindeutige Art und Weise verwendet wird.

6. Verfahren nach einem der Ansprüche 3 und 4, wobei die Verbindungsmatrizen der Paritätskontrollmatrix identisch sind.

7. Verfahren nach Anspruch 6, wobei die Verbindungsmatrizen Identitätsmatrizen sind.

8. Verfahren nach Anspruch 1, **dadurch gekenn-**

**zeichnet, dass** die Dreiecksmatrix eine Bidiagonalmatrix ist, die zwei Diagonalen aus "1" umfasst, die durch eine gegebene Anzahl n von Diagonalen aus "0" beabstandet sind.

9. Verfahren nach einem der Ansprüche 2 bis 8, das ferner einen Schritt zur Punktierung der Paritätsbits des Codeworts umfasst.

10. Kommunikationssystem, das eine erste Einheit (3) umfasst, die eine Informationsquelle (9) und eine Kodierungsvorrichtung (11) umfasst und über einen Datenübertragungskanal (7) mit einer zweiten Einheit (5) verbunden ist, die eine Dekodierungsvorrichtung (13) umfasst, **dadurch gekennzeichnet, dass** die Kodierungsvorrichtung (11) dazu bestimmt ist, eine Datenfolge zu kodieren, die von der Informationsquelle (9) gesendet wird, um eine Menge von Codewörtern ausgehend von einer Paritätskontrollmatrix H zu bilden, wobei:

- jede Spalte der Paritätskontrollmatrix eine bestimmte Anzahl von kodierten Bits definiert, die ein Codewort x bilden, wobei dieses Codewort Datenbits und Paritätsbits umfasst, wobei die Datenbits in eine Menge von Datenvektoren $(C_1, ..., C_i)$ mit $i \geq 2$ zerlegt werden, wobei jeder Datenvektor die gleiche Anzahl von Bits umfasst, und wobei die Paritätsbits zwei Paritätsvektoren $P_1$ und $P_2$ entsprechen;
- jede Zeile der Paritätskontrollmatrix H eine Paritätsgleichung definiert, und
- die Paritätskontrollmatrix H aus zwei Matrixzeilen besteht, wobei jedes Element einer Matrixzeile eine Matrix ist, und jede Matrixzeile mindestens eine sogenannte Verarbeitungsmatrix, mindestens eine sogenannte Verbindungsmatrix, die eine einzige "1" pro Spalte und eine einzige "1" pro Zeile umfasst, eine Nullmatrix 0 und eine Dreiecksmatrix $H_p$ umfasst, wobei die Matrizen auf einer der Matrixzeilen auf die folgende Art und Weise angeordnet sind:

$$H_1 \quad A_2 \ldots \quad H_{i-1} \quad A_i \quad H_p \quad 0$$

und für i = 2 gemäß:

$$H_1 \quad A_2 \quad H_p \quad 0$$

und auf die folgende Art und Weise auf der anderen Matrixzeile:

$$A_1 \quad H_2 \ldots \quad A_{i-1} \quad H_i \quad 0 \quad H_p$$

und für i=2 gemäß:

$$A_1 \quad H_2 \quad 0 \quad H_p$$

wobei $A_1, ..., A_i$ die Verbindungsmatrizen bezeichnen und $H_1, ..., H_i$ die Verarbeitungsmatrizen bezeichnen,
wobei die Verarbeitungs- und Verbindungsmatrizen einen Block bilden, der den Datenbits entspricht, und die Null- und Dreiecksmatrizen einen anderen Block bilden, der den Paritätsbits entspricht,
die Paritätsvektoren $P_1$ und $P_2$ die Menge der Paritätsgleichungen erfüllen, die durch die Paritätskontrollmatrix H und durch die Beziehung $Hx^T = 0^T$ definiert sind, wobei $^T$ den Transpositionsoperator bezeichnet, und gemäß den folgenden Gleichungen berechnet werden können:

$$P_1^T = H_P^{-1}(H_1 C_1^T + \cdots + A_i C_i^T)$$

$$P_2^T = H_P^{-1}(A_1 C_1^T + \cdots + H_i C_i^T)$$

und dadurch, dass die Dekodierungsvorrichtung (13) dazu bestimmt ist, ein kodiertes Empfangssignal zu dekodieren, das durch die zweite Einheit empfangen wird, wobei das kodierte Empfangssignal von der Menge von Codewörtern stammt, die ausgehend von der Paritätskontrollmatrix H gebildet wird.

11. Vorrichtung zum Kodieren einer Datenfolge in ein Codewort x nach einem LDPC-Code, der einer Paritätskontrollmatrix H entspricht, wobei:

- jede Spalte der Paritätskontrollmatrix eine bestimmte Anzahl von kodierten Bits definiert, die das Codewort x bilden, wobei dieses Codewort Datenbits und Paritätsbits umfasst, wobei die Datenbits in eine Menge von Datenvektoren $(C_1, ..., C_i)$ mit $i \geq 2$ zerlegt werden, wobei jeder Datenvektor die gleiche Anzahl von Bits umfasst und die Paritätsbits zwei Paritätsvektoren $P_1$ und $P_2$ entsprechen;
- jede Zeile der Paritätskontrollmatrix H eine Paritätsgleichung definiert, und
- die Paritätskontrollmatrix H aus zwei Matrixzeilen besteht, wobei jedes Element einer Matrixzeile eine Matrix ist, und jede Matrixzeile mindestens eine sogenannte Verarbeitungsmatrix, mindestens eine sogenannte Verbindungsmatrix, die eine einzige "1" pro Spalte und eine einzige "1" pro Zeile umfasst, eine Nullmatrix 0 und

eine Dreiecksmatrix $H_p$ umfasst, wobei die Matrizen auf einer der Matrixzeilen auf die folgende Art und Weise angeordnet sind:

$$H_1 \quad A_2 \ldots \quad H_{i-1} \quad A_i \quad H_p \quad 0$$

und für i = 2 gemäß:

$$H_1 \quad A_2 \quad H_p \quad 0$$

und auf die folgende Art und Weise auf der anderen Matrixzeile:

$$A_1 \quad H_2 \ldots \quad A_{i-1} \quad H_i \quad 0 \quad H_p$$

und für i=2 gemäß:

$$A_1 \quad H_2 \quad 0 \quad H_p$$

wobei $A_1$, ..., $A_i$ die Verbindungsmatrizen bezeichnen und $H_1$, ..., $H_i$ die Verarbeitungsmatrizen bezeichnen,
wobei die Verarbeitungs- und Verbindungsmatrizen einen Block bilden, der den Datenbits entspricht, und die Null- und Dreiecksmatrizen einen anderen Block bilden, der den Paritätsbits entspricht,
die Paritätsvektoren $P_1$ und $P_2$ die Menge der Paritätsgleichungen erfüllen, die durch die Paritätskontrollmatrix H und durch die Beziehung $Hx^T = 0^T$ definiert sind, wobei $^T$ den Transpositionsoperator bezeichnet, und gemäß den folgenden Gleichungen berechnet werden können:

$$P_1^T = H_P^{-1}(H_1 C_1^T + \cdots + A_i C_i^T)$$

$$P_2^T = H_P^{-1}(A_1 C_1^T + \cdots + H_i C_i^T)$$

wobei die Kodierungsvorrichtung Folgendes umfasst:

- ein Mittel zum Zerlegen (21) der Datenfolge in die Menge von Datenvektoren ($C_1$,..., $C_i$), wobei die Menge eine bestimmte Anzahl von Datenvektoren umfasst,
- ein Transformationsmittel (23), das die Menge von Datenvektoren durch eine Menge von Parallelprojektionen in Projektionsvektoren transformiert,
- ein Kodierungsmittel (25), das jeden der Projektionsvektoren mit dem Inversen der Dreiecksmatrix $H_p$ der Paritätskontrollmatrix multipliziert, um die zwei Paritätsvektoren $P_1$ und $P_2$ zu bilden, und
- ein Verknüpfungsmittel (27), das die Menge von Datenvektoren mit den Paritätsvektoren verknüpft, um ein Codewort zu bilden, das mehrere Datenbits und mehrere Paritätsbits umfasst;

und wobei:

- die bestimmte Anzahl von Datenvektoren gleich zwei ist,
- das Transformationsmittel (23) Folgendes umfasst:

  Kontrollmittel (31a, 31b), die parallel den Datenvektor $C_1^T$ mit der Verarbeitungsmatrix $H_1$ der Paritätskontrollmatrix H und den Datenvektor $C_2^T$ mit der Verarbeitungsmatrix $H_2$ der Paritätskontrollmatrix H multiplizieren, wodurch zwei Kontrollvektoren gebildet werden,
  Permutationsmittel (33a, 33b), die parallel den Datenvektor $C_1^T$ mit der Verbindungsmatrix $A_1$ der Paritätskontrollmatrix und den Datenvektor $C_2^T$ mit der Verbindungsmatrix $A_2$ der Paritätskontrollmatrix multiplizieren, wodurch zwei Permutationsvektoren gebildet werden, und
  Additionsmittel (35a, 35b), die die zwei Kontrollvektoren zu den zwei Permutationsvektoren addieren, um die zwei Projektionsvektoren zu bilden, derart, dass ein Kontrollvektor am Ausgang eines Kontrollmittels, das auf einen Datenvektor einwirkt, zu einem Permutationsvektor am Ausgang eines Permutationsmittels addiert wird, das auf den anderen Datenvektor einwirkt.

12. Vorrichtung zum Kodieren einer Datenfolge in ein Codewort x nach einem LDPC-Code, der einer Paritätskontrollmatrix H entspricht, wobei:

    - jede Spalte der Paritätskontrollmatrix eine bestimmte Anzahl von kodierten Bits definiert, die das Codewort x bilden, wobei dieses Codewort Datenbits und Paritätsbits umfasst, wobei die Datenbits in eine Menge von Datenvektoren ($C_1$, ..., $C_i$) mit $i \geq 2$ zerlegt werden, wobei jeder Datenvektor die gleiche Anzahl von Bits umfasst, wobei die Paritätsbits zwei Paritätsvekto-

ren $P_1$ und $P_2$ entsprechen;

- jede Zeile der Paritätskontrollmatrix H eine Paritätsgleichung definiert, und
- die Paritätskontrollmatrix H aus zwei Matrixzeilen besteht, wobei jedes Element einer Matrixzeile eine Matrix ist, und jede Matrixzeile mindestens eine sogenannte Verarbeitungsmatrix, mindestens eine sogenannte Verbindungsmatrix, die eine einzige "1" pro Spalte und eine einzige "1" pro Zeile umfasst, eine Nullmatrix 0 und eine Dreiecksmatrix $H_p$ umfasst, wobei die Matrizen auf einer der Matrixzeilen auf die folgende Art und Weise angeordnet sind:

$$H_1 \quad A_2 \ldots \quad H_{i-1} \quad A_i \quad H_p \quad 0$$

und für i = 2 gemäß:

$$H_1 \quad A_2 \quad H_p \quad 0$$

und auf die folgende Art und Weise auf der anderen Matrixzeile:

$$A_1 \quad H_2 \ldots \quad A_{i-1} \quad H_i \quad 0 \quad H_p$$

und für i=2 gemäß:

$$A_1 \quad H_2 \quad 0 \quad H_p$$

wobei $A_1$, ..., $A_i$ die Verbindungsmatrizen bezeichnen und $H_1$, ... , $H_i$ die Verarbeitungsmatrizen bezeichnen,
wobei die Verarbeitungs- und Verbindungsmatrizen einen Block bilden, der den Datenbits entspricht, und die Null- und Dreiecksmatrizen einen anderen Block bilden, der den Paritätsbits entspricht,
die Paritätsvektoren $P_1$ und $P_2$ die Menge der Paritätsgleichungen erfüllen, die durch die Paritätskontrollmatrix H und durch die Beziehung $Hx^T = 0^T$ definiert sind, wobei $^T$ den Transpositionsoperator bezeichnet, und gemäß den folgenden Gleichungen berechnet werden können:

$$P_1^T = H_P^{-1}(H_1 C_1^T + \cdots + A_i C_i^T)$$

$$P_2^T = H_P^{-1}(A_1 C_1^T + \cdots + H_i C_i^T)$$

wobei die Kodierungsvorrichtung Folgendes umfasst:

- ein Mittel zum Zerlegen (21) der Datenfolge in die Menge von Datenvektoren ($C_1$,..., $C_i$), wobei die Menge eine bestimmte Anzahl von Datenvektoren umfasst,
- ein Transformationsmittel (23), das die Menge von Datenvektoren durch eine Menge von Parallelprojektionen in Projektionsvektoren transformiert,
- ein Kodierungsmittel (25), das jeden der Projektionsvektoren mit dem Inversen der Dreiecksmatrix $H_p$ der Paritätskontrollmatrix multipliziert, um die zwei Paritätsvektoren $P_1$ und $P_2$ zu bilden, und
- ein Verknüpfungsmittel (27), das die Menge von Datenvektoren mit den Paritätsvektoren verknüpft, um ein Codewort zu bilden, das mehrere Datenbits und mehrere Paritätsbits umfasst;

und wobei:

- die bestimmte Anzahl von Datenvektoren $C_1$, ..., $C_i$ größer als zwei ist,
- das Transformationsmittel (23) Folgendes umfasst:

    Kontrollmittel (31a bis 31d), die parallel jeden Datenvektor $C_j^T$, j=1, ..., i jeweils mit jeder Verarbeitungsmatrix $H_j$, j=1,..., i der Paritätskontrollmatrix multiplizieren, wodurch eine Menge von Kontrollvektoren gebildet wird,

    Permutationsmittel (33a bis 33d), die parallel jeden Datenvektor $C_j^T$, j=1, ..., i jeweils mit jeder Verbindungsmatrix $A_j$, j=1,..., i der Paritätskontrollmatrix multiplizieren, wodurch eine Menge von Permutationsvektoren gebildet wird, und

    erste Additionsmittel (35a bis 35d), die die Menge von Kontrollvektoren zu der Menge von Permutationsvektoren addieren, um eine Menge von Projektionsvektoren zu bilden, derart, dass ein Kontrollvektor am Ausgang eines Kontrollmittels, das auf irgendeinen Datenvektor einwirkt, zu einem Permutationsvektor am Ausgang eines Permutationsmittels addiert wird, das auf einen anderen Datenvektor einwirkt, und

    zweite Additionsmittel (45a, 45b), die die Projektionsvektoren der Menge von Projektionsvektoren aufeinanderfolgend paarweise addieren, bis zwei Projektionsvektoren erhalten werden.

**13.** Computerprogramm, das durch ein Informatiksystem eingesetzt wird, das Befehle umfasst, die für die Ausführung des Kodierungsverfahrens nach einem der Ansprüche 2 bis 9 erforderlich sind.

**Claims**

1. Method encoding a data sequence into a code word x according to an LDPC code corresponding to a parity check matrix H, in which:

   - each column of said parity check matrix H defines a determined number of coded bits forming the code word x, said code word comprising data bits and parity bits, said data bits being decomposed into a set of data vectors $(C_1,...,C_i)$ with $i \geq 2$, each data vector comprising the same number of bits, said parity bits corresponding to two parity vectors $P_1$ and $P_2$;
   - each row of said parity check matrix H defines a parity equation,
   - said parity check matrix H consists of two matrix rows, each element of a matrix row being a matrix, and each matrix row comprising at least one so-called processing matrix and one so-called linking matrix comprising a single "1" per column and a single "1" per row, a zero matrix 0 and a triangular matrix $H_p$,

   said matrixes being disposed in the following manner on one of the matrix rows:

   $$H_1 \quad A_2 \quad ... \quad H_{i-1} \quad A_i \quad H_p \quad 0$$

   and for i=2 according to:

   $$H_1 \quad A_2 \quad H_p \quad 0$$

   and in the following manner on the other matrix row:

   $$A_1 \quad H_2 \quad ... \quad A_{i-1} \quad H_i \quad 0 \quad H_p$$

   and for i=2 according to:

   $$A_1 \quad H_2 \quad 0 \quad H_p$$

   $A_1,...,A_i$ designating the linking matrixes and $H_1,...,H_i$ designating the processing matrixes, the processing and linking matrixes forming a block corresponding to the data bits and the zero and triangular matrixes forming another block corresponding to the parity bits, the parity vectors $P_1$ and $P_2$ complying with the set of parity equations defined by the parity check matrix H and by the relation $Hx^T=0^T$ where $^T$ designates the transposition operator, and being calculatable according to the following equations:

$$P_1{}^T = H_P{}^{-1} (H_1 C_1{}^T + ... + A_i C_i{}^T)$$

$$P_2{}^T = H_P{}^{-1} (A_1 C_1{}^T + ... + H_i C_i{}^T).$$

2. Method of encoding according to Claim 1, comprising the following steps:

   - decomposing the data sequence into said set of data vectors $(C_1,...,C_i)$ said set comprising a determined number of data vectors,
   - determination, by using the parity check matrix H, of the parity vectors $P_1$ and $P_2$ corresponding to the data vectors $(C_1,...,C_i)$ and complying with the set of parity equations defined by said parity check matrix H and by the relation $Hx^T = 0^T$ where $^T$ designates the transposition operator, and
   - associating the set of data vectors with the parity vectors to form a code word comprising a plurality of data bits and a plurality of parity bits.

3. Method of encoding according to Claim 2 comprising the following steps:

   - transforming by a set of parallel projections said set of data vectors into two projection vectors,
   - multiplying each of the projection vectors by the inverse of the triangular matrix $H_p$ of said parity check matrix to form said parity vectors $P_1$ and $P_2$;

   and in which:

   - the determined number of data vectors $C_1$, $C_2$ is equal to two,
   - the step of transformation by parallel projections comprises the following steps:

      carrying out operations in parallel comprising check and permutation operations on said two data vectors so as to form two check vectors and two permutation vectors, said check operations comprising the multiplication of the data vector $C_1{}^T$ by the processing matrix $H_1$ of the parity check matrix H and the multiplication of the data vector $C_2{}^T$ by the processing matrix $H_2$ of the parity check matrix H, and said permutation operations comprising the multiplication of

the data vector $C_1^T$ by the linking matrix $A_1$ of said parity check matrix and the multiplication of the data vector $C_2^T$ by the linking matrix $A_2$ of said parity check matrix; and adding said two check vectors to said two permutation vectors so as to form a set of projection vectors consisting of said two projection vectors in such a way that a check vector arising from a check operation on a data vector is added to a permutation vector arising from a permutation operation on the other data vector.

4. Method according to Claim 2 comprising the following steps:

- transforming by a set of parallel projections said set of data vectors into two projection vectors,
- multiplying each of the projection vectors by the inverse of the triangular matrix $H_p$ of said parity check matrix so as to form said parity vectors $P_1$ and $P_2$;

and in which:

- the determined number of data vectors $C_1,...,C_i$ is greater than two,
- the step of transformation by parallel projections comprises the following steps:

carrying out operations in parallel comprising check and permutation operations on said set of data vectors so as to form a set of check vectors and a set of permutation vectors, said check operations comprising the multiplication of each data vector $C_j^T$, j=1,...,i by the processing matrix $H_j$, j=1,...,i of the parity check matrix and said permutation operations comprising the multiplication of each data vector $C_j^T$, j=1,...,i by the linking matrix $A_j$, j=1,...,i of the parity check matrix; adding said set of check vectors to said set of permutation vectors so as to form a set of projection vectors in such a way that a check vector arising from a check operation on any data vector is added to a permutation vector arising from a permutation operation on another data vector, and adding pair wise the projection vectors of said set of projection vectors so as to form another set of projection vectors, the addition being carried out between two projection vectors not depending on the same data vectors, and if the other set of projection vectors comprises more than two projection vectors, then recommencing the previous step until two projection vectors are obtained.

5. Method according to any one of Claims 3 and 4, in which during the formation of said set of projection vectors, each permutation vector of said set of permutation vectors is used in a unique manner.

6. Method according to any one of Claims 3 and 4, in which the linking matrixes of said parity check matrix are identical.

7. Method according to Claim 6, in which said linking matrixes are identity matrixes.

8. Method according to Claim 1, **characterized in that** the triangular matrix is a bi-diagonal matrix comprising two diagonals of "1s" spaced apart by a given number n of diagonals of "0s".

9. Method according to any one of Claims 2 to 8, comprising furthermore a step of puncturing the parity bits of said code word.

10. Communication system comprising a first entity (3) comprising an information source (9) and an encoder device (11), connected via a data transmission channel (7) to a second entity (5) comprising a decoder device (13), **characterized in that** the encoder device (11) is intended to encode a data sequence emitted by the information source (9) so as to form a set of code words on the basis of a parity check matrix H, in which:

- each column of said parity check matrix defines a determined number of coded bits forming a code word x, said code word comprising data bits and parity bits, said data bits being decomposed into a set of data vectors $(C_1,...,C_i)$ with $i \geq 2$, each data vector comprising the same number of bits, and said parity bits corresponding to two parity vectors $P_1$ and $P_2$;
- each row of said parity check matrix H defines a parity equation, and
- said parity check matrix H consists of two matrix rows, each element of a matrix row being a matrix, and each matrix row comprising at least one so-called processing matrix, at least one so-called linking matrix comprising a single "1" per column and a single "1" per row, a zero matrix 0 and a triangular matrix $H_p$, said matrixes being disposed in the following manner on one of the matrix rows:

$$H_1 \; A_2 \; \ldots \; H_{i-1} \; A_i \; H_p \; 0$$

and for i=2 according to:

$$H_1 \; A_2 \; H_p \; 0$$

and in the following manner on the other matrix row:

$$A_1 \; H_2 \; \ldots \; A_{i-1} \; H_i \; 0 \; H_p$$

and for i=2 according to:

$$A_1 \; H_2 \; 0 \; H_p$$

$A_1,...,A_i$ designating the linking matrixes and $H_1,...,H_i$ designating the processing matrixes, the processing and linking matrixes forming a block corresponding to the data bits and the zero and triangular matrixes forming another block corresponding to the parity bits, the parity vectors $P_1$ and $P_2$ complying with the set of parity equations defined by the parity check matrix H and by the relation $Hx^T=0^T$ where $^T$ designates the transposition operator, and being calculatable according to the following equations:

$$P_1^T \; = \; H_P^{-1}(H_1C_1^T \; + \; \ldots \; + \; A_iC_i^T)$$

$$P_2^T \; = \; H_P^{-1}(A_1C_1^T \; + \; \ldots \; + \; H_iC_i^T)$$

and **in that** the decoder device (13) is intended to decode a coded reception signal received by the second entity, said coded reception signal emanating from the set of code words formed on the basis of said parity check matrix H.

11. Device encoding a data sequence into a code word x according to an LDPC code corresponding to a parity check matrix H, in which:

- each column of said parity check matrix defines a determined number of coded bits forming the code word x, said code word comprising data bits and parity bits, said data bits being decomposed into a set of data vectors $(C_1,...,C_i)$ with i≥2, each data vector comprising the same number of bits, and said parity bits corresponding to two parity vectors $P_1$ and $P_2$;
- each row of said parity check matrix H defines a parity equation, and
- said parity check matrix H consists of two matrix rows, each element of a matrix row being a matrix, and each matrix row comprising at least one so-called processing matrix, at least one so-called linking matrix comprising a single "1" per column and a single "1" per row, a zero matrix 0 and a triangular matrix $H_p$, said matrixes being disposed in the following manner on one of the matrix rows:

$$H_1 \; A_2 \; \ldots \; H_{i-1} \; A_i \; H_p \; 0$$

and for i=2 according to:

$$H_1 \; A_2 \; H_p \; 0$$

and in the following manner on the other matrix row:

$$A_1 \; H_2 \; \ldots \; A_{i-1} \; H_i \; 0 \; H_p$$

and for i=2 according to:

$$A_1 \; H_2 \; 0 \; H_p$$

$A_1,...,A_i$ designating the linking matrixes and $H_1,...,H_i$ designating the processing matrixes, the processing and linking matrixes forming a block corresponding to the data bits and the zero and triangular matrixes forming another block corresponding to the parity bits, the parity vectors $P_1$ and $P_2$ complying with the set of parity equations defined by the parity check matrix H and by the relation $Hx^T=0^T$ where $^T$ designates the transposition operator, and being calculatable according to the following equations:

$$P_1^T \; = \; H_P^{-1}(H_1C_1^T \; + \; \ldots \; + \; A_iC_i^T)$$

$$P_2^T \; = \; H_P^{-1}(A_1C_1^T \; + \; \ldots \; + \; H_iC_i^T)$$

said encoding device comprising:

- a means of decomposition (21) for decomposing the data sequence into said set of data vectors $(C_1,...,C_i)$, said set comprising a determined number of data vectors,
- a means of transformation (23) transforming by a set of parallel projections said set of data vectors into projection vectors,
- a means of coding (25) multiplying each of the projection vectors by the inverse of said triangular matrix $H_p$ of said parity check matrix so as to form said two parity vectors $P_1$ and $P_2$, and

- a means of association (27) associating the set of data vectors with said parity vectors to form a code word comprising a plurality of data bits and a plurality of parity bits;

and in which:

- the determined number of data vectors is equal to two,
- the means of transformation (23) comprises:

check means (31a, 31b) multiplying in parallel the data vector $C_1^T$ by the processing matrix $H_1$ of the parity check matrix H and the data vector $C_2^T$ by the processing matrix $H_2$ of the parity check matrix H forming two check vectors,

permutation means (33a, 33b) multiplying in parallel the data vector $C_1^T$ by the linking matrix $A_1$ of said parity check matrix and the data vector $C_2^T$ by the linking matrix $A_2$ of said parity check matrix forming two permutation vectors, and

means of addition (35a, 35b) adding said two check vectors to said two permutation vectors so as to form said two projection vectors in such a way that a check vector arising from a check means acting on a data vector is added to a permutation vector arising from a permutation means acting on the other data vector.

12. Device encoding a data sequence into a code word x according to an LDPC code corresponding to a parity check matrix H, in which:

- each column of said parity check matrix defines a determined number of coded bits forming the code word x, said code word comprising data bits and parity bits, said data bits being decomposed into a set of data vectors $(C_1,...,C_i)$ with i≥2, each data vector comprising the same number of bits, and said parity bits corresponding to two parity vectors $P_1$ and $P_2$;
- each row of said parity check matrix H defines a parity equation, and
- said parity check matrix H consists of two matrix rows, each element of a matrix row being a matrix, and each matrix row comprising at least one so-called processing matrix, at least one so-called linking matrix comprising a single "1" per column and a single "1" per row, a zero matrix 0 and a triangular matrix $H_p$, said matrixes being disposed in the following manner on one of the matrix rows:

$$H_1 \quad A_2 \quad \ldots \quad H_{i-1} \quad A_i \quad H_p \quad 0$$

and for i=2 according to:

$$H_1 \quad A_2 \quad H_p \quad 0$$

and in the following manner on the other matrix row:

$$A_1 \quad H_2 \quad \ldots \quad A_{i-1} \quad H_i \quad 0 \quad H_p$$

and for i=2 according to:

$$A_1 \quad H_2 \quad 0 \quad H_p$$

$A_1,...,A_i$ designating the linking matrixes and $H_1,...,H_i$ designating the processing matrixes, the processing and linking matrixes forming a block corresponding to the data bits and the zero and triangular matrixes forming another block corresponding to the parity bits, the parity vectors $P_1$ and $P_2$ complying with the set of parity equations defined by the parity check matrix H and by the relation $Hx^T=0^T$ where $^T$ designates the transposition operator, and being calculatable according to the following equations:

$$P_1^T = H_p^{-1}(H_1 C_1^T + \ldots + A_i C_i^T)$$

$$P_2^T = H_p^{-1}(A_1 C_1^T + \ldots + H_i C_i^T)$$

said encoding device comprising:

- a means of decomposition (21) for decomposing the data sequence into said set of data vectors $(C_1,...,C_i)$, said set comprising a determined number of data vectors,
- a means of transformation (23) transforming by a set of parallel projections said set of data vectors into projection vectors,
- a means of coding (25) multiplying each of the projection vectors by the inverse of said triangular matrix $H_p$ of said parity check matrix so as to form said two parity vectors $P_1$ and $P_2$, and
- a means of association (27) associating the set of data vectors with said parity vectors so as to form a code word comprising a plurality of data bits and a plurality of parity bits;

and in which:

- the determined number of data vectors $C_1,...,C_i$ is greater than two,
- the means of transformation (23) comprises:

check means (31a to 31d) multiplying in parallel each data vector $C_j^T$, j=1,...,i by each processing matrix $H_j$, j=1,...,i respectively of said parity check matrix forming a set of check vectors,

permutation means (33a to 33d) multiplying in parallel each data vector $C_j^T$, j=1,...,i by each linking matrix $A_j$, j=1,...,i respectively of said parity check matrix forming a set of permutation vectors, and

first means of addition (35a to 35d) adding said set of check vectors to said set of permutation vectors so as to form a set of projection vectors in such a way that a check vector arising from a check means acting on any data vector is added to a permutation vector arising from a permutation means acting on another data vector, and

second means of addition (45a, 45b) adding successively pair wise the projection vectors of the set of projection vectors until two projection vectors are obtained.

13. Computer program implemented in a computing system, comprising instructions necessary for carrying out the method of encoding according to any one of Claims 2 to 9.

**FIG.1**

**FIG.4A**

**FIG.4B**

**FIG.5**

FIG.2

S

S6 ⟶ S1 ⟶ S6

S4 ⟵ S2 | S1 | S2 ⟶ S5

S6 | S6 | S2 | S6

S3

## FIG.3

39a

V₁ ⟶ 41a ⟶ 41b ⟶ 43 ⟶ P₁

41a ⟶ 41b ⟶ 43

41a ⟶ 41b ⟶ 43

## FIG.6

FIG.7

FIG.9

FIG.10
ART ANTERIEUR

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MICHAEL YANG ; W.E. RYAN ; YAN LI.** Design of efficiently encodable moderate-length high-rate irregular LDPC codes. *IEEE Transactions on Communications,* Avril 2004
- **S.J. JOHNSON ; S.R. WELLER.** Quasi-cyclic LDPC codes from differences families. *3rd Australian Communications Theory Worshop,* Février 2002
- The pi rotation Low Density Parity Check Codes. **R.ECHARD ; S-C CHANG.** GLOBECOM. 20 Novembre 2001, vol. 01, 980-984
- **R.ECHARD ; S-C CHANG.** The pi rotation Low Density Parity Check Codes. *GLOBECOM,* Novembre 2001, 980-984
- **XIAO-YU HU et al.** On the computation of the minimum distance of low-density parity-check codes. *ICC 2004 - IEEE International Conference on Communications,* Juin 2004, vol. 27 (1), 767-771